# EUROPEAN PATENT APPLICATION

(11) **EP 4 766 054 A1**
(43) Date of publication of application: **24.06.2026**
(21) Application number: 24903940.5
(22) Date of filing: 22.10.2024
(51) Int. Cl.: H05K 7/20, H04M 1/02, G06F 1/20, G06F 1/16

(54) **PORTABLE ELECTRONIC DEVICE COMPRISING HEAT DISSIPATION STRUCTURE AND BATTERY**

(30) Priority: 15.12.2023 KR 20230182738; 27.12.2023 KR 20230192750; 28.02.2024 KR 20240028849
(71) Applicant: Samsung Electronics Co., Ltd., Suwon-si, Gyeonggi-do 16677 (KR)
(72) Inventor: LEE, Yongseok, Suwon-si Gyeonggi-do 16677 (KR); MOON, Heecheul, Suwon-si Gyeonggi-do 16677 (KR)
(74) Representative: Gulde & Partner
(86) International application number: PCT/KR2024/016056
(87) International publication number: WO 2025/127373

(57) **Abstract**

An electronic device includes a support member, a display module, a printed circuit board, a battery, a heat dissipation structure, and a double-sided adhesive member. The heat dissipation structure includes a first portion which is disposed on a first area of the support member, and a second portion which is disposed on an opening of the support member. The second portion is exposed to a rear surface of the support member through the opening of the support member. The double-sided adhesive member includes a front surface including a non-adhesive area that faces the second portion of the heat dissipation structure while not being adhered to the second portion, and a rear surface including an adhesive area that is adhered to the battery.

## Description

### BACKGROUND

### 1. Field

Various embodiments of the disclosure relate to a portable electronic device including a heat dissipation structure and a battery.

### 2. Description of Related Art

Portable electronic devices, such as smartphones, tablets, notebooks, slate personal computer (PCs), or laptops, may support communication functions and various content providing functions based on various types of applications. In this regard, a portable electronic device includes a battery, and provides various functions by using battery power.

Meanwhile, a portable electronic device may be manufactured (or provided) to have an overall small size for portability. Although the size of the portable electronic device is reduced, functions provided by the portable electronic device are maintained or further diversified. Thus, with respect to user functions, frequencies and speeds of use of various electronic components are increased, and handling of heat generation issues resulting therefrom becomes important. In this regard, a portable electronic device is provided with a heat dissipation structure for handling heat generated from electronic components. In a portable electronic device which is being slimmed or lightened, an appropriate arrangement of the heat dissipation structure and the battery may be considered.

The above information may be provided as background technology (related art) for helping understanding of the disclosure. None of the above description should be asserted as prior art related to the disclosure, or used for determining prior art.

### SUMMARY

A portable electronic device (or a portable communication device) according to various embodiments of the disclosure may include a support member which includes an opening, a display module, a printed circuit board, and a battery, a heat dissipation structure, and a double-sided adhesive member, where the heat dissipation structure includes a first portion which is positioned in a first area of the support member, and a second portion that at least partially overlaps with the opening of the support member, and the second portion is exposed to a rear surface of the support member through the opening, and the double-sided adhesive member may include a front surface (or an upper surface) which includes a first adhesive area and a non-adhesive area which faces the second portion of the heat dissipation structure while being non-adhered to the second portion, and a rear surface (or a lower surface) which includes a second adhesive area adhered to the battery.

In addition, various embodiments are disclosed.

### BRIEF DESCRIPTION OF THE DRAWINGS

FIG. 1A is a view illustrating an example of a front surface of a portable electronic device according to an embodiment.
FIG. 1B is a view illustrating an example of a rear surface of a portable electronic device according to an embodiment.
FIG. 1C is a view illustrating an example of an exploded perspective view of a first-type portable electronic device according to an embodiment.
FIGS. 2A and 2B are views illustrating an example of a plan view and a cross-sectional view of a portion of a first-type portable electronic device according to an embodiment.
FIGS. 3A, 3B and 3C are views illustrating an example of a plan view and cross-sectional views of a portion of a first-type portable electronic device according to an embodiment.
FIGS. 4A, 4B and 4C are views illustrating an example of some components of a first-type portable electronic device including a first-type fixing structure, a support member, and a heat dissipation structure according to an embodiment.
FIG. 5 is a view illustrating an exploded perspective view of a second-type portable electronic device according to an embodiment.
FIGS. 6A and 6B are views illustrating an example of plan views a second-type fixing structure and a third mask member according to an embodiment.
FIGS. 7A, 7B, 7C and 7D are views illustrating plan views of a disposition form of a support member and some peripheral components of a second-type portable electronic device according to an embodiment.
FIGS. 8A, 8B, 8C, 8D and 8E are views illustrating an example of a plan view and cross-sectional views of one side of a support member, with one side thereof cut away, on which a second-type fixing structure is disposed, according to an embodiment.
FIGS. 9A, 9B, 9C and 9D are views illustrating an example of an assembly sequence of a second-type portable electronic device according to an embodiment.
FIG. 10 is a view illustrating an example of an exploded perspective view of a third-type portable electronic device according to an embodiment.
FIGS. 11A, 11B, 11C, 11D and 11E are views illustrating an example of perspective views of some components of a third-type portable electronic device, taken along cutting line A3-A3', according to an embodiment.
FIGS. 12A and 12B are views illustrating an example of a perspective view and a cross-sectional view of an assembly sequence of some components of a third-type portable electronic device according to an embodiment.
FIGS. 13A, 13B and 13C are views illustrating an example of cross-sectional views at least some components of a fixing structure according to an embodiment.
FIGS. 14A and 14B are views illustrating an example of a structure of a fourth-type portable electronic device according to an embodiment.

### DETAILED DESCRIPTION

Hereinafter, various embodiments of the disclosure may be described with reference to accompanying drawings.

For example, hereinafter, a portable electronic device according to various embodiments of the present disclosure may include a heat dissipation structure (or a heat circulation device) and a support member which supports a display (or a bracket, a frame, a front frame, a housing, or a case). The support member may provide a space in which the heat dissipation structure and a battery are disposed, and may include a structure which spaces the heat dissipation structure apart from the support member. Such a structure may support facilitating disassembly of the portable electronic device through an independent arrangement from a battery, in a structure in which heat generated from electronic components of the portable electronic device is diffused to the heat dissipation structure.

The objects according to various embodiments of the disclosure will be described as necessary in a process of describing the embodiments.

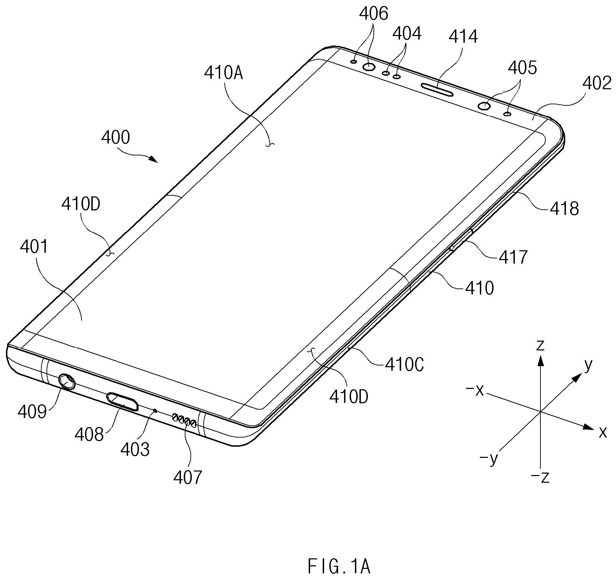

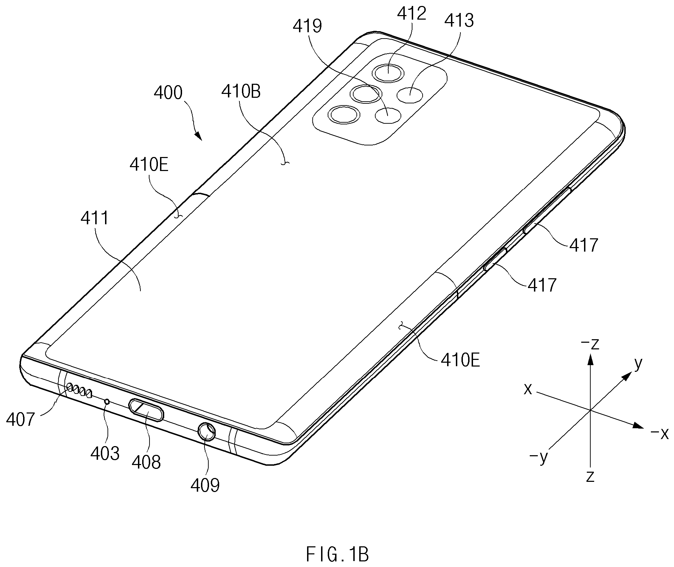

FIG. 1A is a view illustrating an example of a front surface of a portable electronic device according to an embodiment. FIG. 1B is a view illustrating an example of a rear surface of a portable electronic device according to an embodiment.

Referring to FIGS. 1A and 1B, a portable electronic device 400 (or an electronic device or a portable communication device) according to an embodiment may include a housing 410 including a first surface (or a front surface) 410A, a second surface (or a rear surface) 410B, and a side surface 410C which surrounds a space between the first surface 410A and the second surface 410B. According to an embodiment (not illustrated), the housing may also refer to a structure which forms some of the first surface 410A, the second surface 410B, and the side surface(s) 410C of FIG. 1A. According to an embodiment, the first surface 410A may be formed by a first plate (or a front plate) 402 (e.g., a glass plate including various coating layers, or a polymer plate), at least part of which is substantially transparent. The second surface 410B may be formed by a rear plate 411 which is substantially opaque. For example, the rear plate 411 may be formed of a coated or colored glass, a ceramic, a polymer, a metal (e.g., aluminum, stainless steel (STS), or magnesium), or the combination of at least two of the materials. The side surface 410C may be coupled with the front plate 402 and the rear plate 411, and may be formed by a side bezel structure (or a "side member") 418 including metal and/or polymer. In any embodiment, the rear plate 411 and the side bezel structure 418 may be integrally formed and may include the same material (e.g., a metal material such as aluminum).

In the illustrated embodiment, the front plate 402 may include two first areas 410D, which are curved toward the rear plate 411 from the first surface 410A so as to be seamlessly extended, at opposite long edges of the front plate 402. In the illustrated embodiment (refer to FIG. 1B), the rear plate 411 may include two second areas 410E, which are curved toward the front plate 402 from the second surface 410B so as to be seamlessly extended, at opposite long edges thereof. In some embodiments, the front plate 402 (or the rear plate 411) may include only one of the first areas 410D (or the second areas 410E). In an embodiment, some of the first areas 410D or the second areas 410E may not be included. In the embodiments, when viewed from a side surface of the portable electronic device 400, the side bezel structure 418 may have a first thickness (or width) on one side where the first areas 410D or the second areas 410E are not included, and may have a second thickness, which is smaller than the first thickness, on one side where the first areas 410D or the second areas 410E are included.

According to an embodiment, the portable electronic device 400 may include at least one of a display 401, an audio module 403, 407, and 414, a sensor module 404 and 419, a camera module 405, 412, and 413, a key input device 417, a light emitting element 406, and a connector hole 408 and 409. In some embodiments, the portable electronic device 400 may omit at least one of the components (e.g., the key input device 417 or the light emitting element 406), or may further include another component.

For example, the display 401 may be exposed through a substantial portion of the front plate 402. In some embodiments, at least a portion of the display module 401 may be exposed through the first surface 410A and the front plate 402 forming the first areas 410D of the side surface 410C. In an embodiment, a corner of the display 401 may be formed to be mostly identical to a shape of an outer portion of the front plate 402 adjacent thereto. In an embodiment (not illustrated), to expand an extent in which the display 401 is exposed, a spacing between an outer edge of the display 401 and an outer edge of the front plate 402 may be formed to be substantially uniform.

In an embodiment (not illustrated), a recess or an opening may be formed at or in a portion of a screen display area of the display 401, and the portable electronic device may include at least one of an audio module 414, a sensor module 404, a camera module 405, and a light emitting element 406 which are aligned with the recess or the opening. In an embodiment (not illustrated), at least one of an audio module 414, a sensor module 404, a camera module 405, a fingerprint sensor, and a light emitting element 406 may be disposed on a rear surface of a screen display area of the display 401. In an embodiment (not illustrated), the display 401 may be coupled to a touch sensing circuit, a pressure sensor which is capable of measuring an intensity (pressure) of a touch, and/or a digitizer which is capable of detecting a magnetic stylus pen, or may be disposed adjacent thereto. In some embodiments, at least a portion of the sensor module 404 and 419 and/or at least a portion of the key input device 417 may be disposed in the first areas 410D and/or the second areas 410E.

The audio module 403, 407, and 414 may include a microphone hole 403 and speaker holes 407 and 414. A microphone for obtaining external sound may be disposed in the microphone hole 403, and in some embodiments, a plurality of microphones may be disposed to detect a direction of sound. The speaker holes 407 and 414 may include an external speaker hole 407 and a receiver hole 414 for a call. In some embodiments, the speaker holes 407 and 414 and the microphone hole 403 may be implemented as a single hole, or a speaker may be included without the speaker holes 407 and 414 (e.g., a piezo speaker).

The sensor module 404 and 419 may generate an electrical signal or a data value which corresponds to an internal operation state of the portable electronic device 400 or an external environment state. The sensor module 404 and 419 may include, for example, a first sensor module 404 (e.g., a proximity sensor) and/or a second sensor module (not illustrated) (e.g., a fingerprint sensor) disposed on a first surface 410A of a housing 410, and/or a third sensor module 419 (e.g., a heart rate monitor (HRM) sensor) and/or a fourth sensor module (e.g., a fingerprint sensor) disposed on a second surface 410B of the housing 410. The fingerprint sensor may be disposed not only on the first surface 410A of the housing 410 (e.g., on the display module 401) but also on the second surface 410B. The portable electronic device 400 may further include a sensor module not illustrated, for example, at least one of a gesture sensor, a gyro sensor, a barometric pressure sensor, a magnetic sensor, an acceleration sensor, a grip sensor, a color sensor, an infrared (IR) sensor, a biometric sensor, a temperature sensor, a humidity sensor, or an illumination sensor 404.

The camera module 405, 412, and 413 may include a first camera device 405 disposed on the first surface 410A of the portable electronic device 400, and a second camera device 412, and/or a flash 413 disposed on the second surface 410B. The camera device 405 and 412 may include one or more lenses, an image sensor, and/or an image signal processor. The flash 413 may include, for example, a light emitting diode (LED) or a xenon lamp. In an embodiment, two or more lenses (e.g., an infrared camera and wide-angle and telephoto lenses) and image sensors may be disposed on one surface of portable the electronic device 400.

The key input device 417 may be disposed on a side surface 410C of the housing 410. According to an embodiment, the portable electronic device 400 may not include some or all of the above-mentioned key input device 417, and a key input device 417 which is not included may be implemented on the display 401 in another form, such as a soft key. In some embodiments, the key input device may include a sensor module disposed on a second surface 410B of the housing 410.

The light emitting element 406 may be disposed, for example, on the first surface 410A of the housing 410. The light emitting element 406 may provide state information of the portable electronic device 400, for example, in a form of light. According to an embodiment, the light emitting element 406 may provide, for example, a light source which operates in conjunction with an operation of the camera module 405. The light emitting element 406 may include, for example, an LED, an IR LED, and a xenon lamp.

The connector hole 408 and 409 may include a first connector hole 408 which is capable of accommodating a connector (for example, a USB connector) for transmitting and/or receiving power and/or data with a portable electronic device, and/or a second connector hole (for example, an earphone jack) 409 which is capable of accommodating a connector for transmitting and/or receiving an audio signal with an external electronic device.

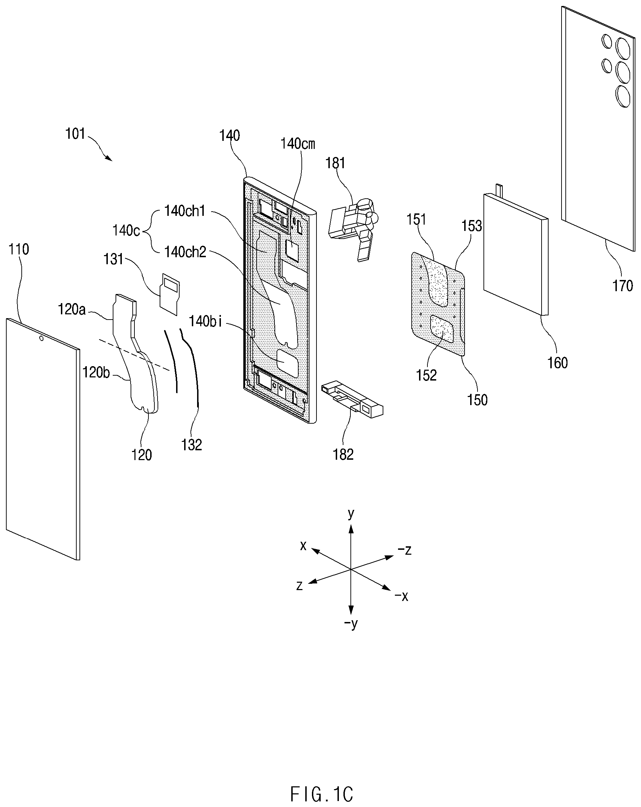

FIG. 1C is a view illustrating an example of an exploded perspective view of a first-type portable electronic device according to an embodiment. The first-type portable electronic device 101 may include at least some components of the portable electronic device 400 described above with reference to FIGS. 1A and 1B.

Referring to FIG. 1C, the first-type portable electronic device 101 may include a support member 140 (e.g., a bracket, a frame, or a housing), a display module 110 (or a display assembly, a display structure, or a display assembly) (e.g., a structure including the front plate 402 and the display 401 of FIGS. 1A and 1B), printed circuit boards 181 and 182, a battery 160, and a rear case 170 (e.g., the rear plate 411 of FIGS. 1A and 1B). According to an embodiment, the first-type portable electronic device 101 may include a heat dissipation structure 120, at least a portion of which is disposed between the support member 140 and the display module 110, and a first-type fixing structure 150 (or a first battery fixing structure, a first battery adhesive structure, a first adhesive structure, a first adhesive member, a first adhesive assembly, a double-sided adhesive member, or a double-sided adhesive tape) which is disposed between the support member 140 and the battery 160. According to an embodiment, the first-type portable electronic device 101 may include first and second adhesive members 131 and 132 which contact or are adhered to the heat dissipation structure 120.

In some embodiments, the first-type portable electronic device 101 may exclude, among the above-described components, at least one (e.g., any one of some printed circuit boards (e.g., the printed circuit board 181 or 182), or any one of the first and second adhesive members 131 and 132), or may include another form of components or modified components (e.g., a form in which the printed circuit boards 181 and 182 are connected to each other or integrated with each other, or a form in which the first and second adhesive members 131 and 132 are integrated with each other or connected to each other). At least one of the components of the first-type portable electronic device 101 may be the same as or similar to at least one of the components of the portable electronic device 400 of FIG. 1A or FIG. 1B, and repeated descriptions of the same or similar components will be omitted.

According to an embodiment, at least a portion of the support member 140 may be disposed in an interior of the first-type portable electronic device 101 (or covered by another component), and at least a portion thereof may include a portion (e.g., a side bezel structure) which is exposed to an outside. Alternatively, the support member 140 may be disposed in an interior of the first-type portable electronic device 101 so as not to be observed from an outside, and may be covered by another component. At least a portion of, or the entirety of, the support member 140, or a certain proportion thereof, may include, for example, a metal material and/or a non-metal material (e.g., a polymer material). The display module 110 may be disposed in one surface direction (e.g., the z-axis direction) of the support member 140, and the printed circuit boards 181 and 182 may be disposed in an opposite surface (or a second surface of the support member 140) direction (e.g., the -z-axis direction). At least a portion of the support member 140 may include a first area (or a first portion or a first structure) which is formed of a first material (e.g., a first metallic material), and a second area (or a second portion or a second structure) which is formed of a second material (e.g., a material different from the first material, such as a second metallic material different from the first metallic material, or an injection-molded material). The shapes, ratios, and distribution forms of the above-described first area and second area may be changed depending on a shape or a structure of the first-type portable electronic device 101. As an example, the support member 140 may be formed of only one material (e.g., a metallic material or an injection-molding material). Various parts (or components) may be disposed on the support member 140.

According to an embodiment, the support member 140 may include a first surface (or a front surface, a surface which faces the z-axis direction, a surface on which the display module 110 is positioned, or a surface which faces a direction in which the display module 110 is positioned), and a second surface (or a rear surface, a surface which faces the -z-axis direction, or a surface which faces a direction in which the printed circuit boards 181 and 182 and/or the battery 160 are positioned). The support member 140 may include a structure disposition area 140c, in which the heat dissipation structure 120 is disposed. The structure disposition area 140c may include a first structure disposition area 140ch1, in which a first portion 120a of the heat dissipation structure 120 is disposed, and a second structure disposition area 140ch2, in which a second portion 120b (e.g., another portion which is connected to the first portion 120a) of the heat dissipation structure 120 is disposed. The first structure disposition area 140ch1 may include a groove structure, in which at least a portion of a front surface (e.g., a surface which faces the z-axis) is formed to be stepped toward a rear surface (e.g., a surface which faces the -z-axis). At least a portion of a surface of the first structure disposition area 140ch1 which faces the -z-axis direction may contact at least one electronic component (e.g., an application processor (AP)) disposed on the printed circuit boards 181 and 182 (e.g., in a direct contact state or in a contact state through a heat transfer member). The second structure disposition area 140ch2 may include a structure, at least a portion of which is removed in consideration of a thickness of the battery 160 for slimming (e.g., a through part or a hole structure which is formed to pass through a front surface and a rear surface (e.g., a surface which faces the z-axis and a surface which faces the -z-axis)). Correspondingly, when the heat dissipation structure 120 is disposed in the second structure disposition area 140ch2 of the support member 140, the second portion 120b of the heat dissipation structure 120 may directly face the first-type fixing structure 150, or at least a portion of the second portion 120b may contact the first-type fixing structure 150. The support member 140 may include a sensor disposition area 140bi, in which a specific sensor (e.g., a fingerprint sensor) is disposed. The sensor disposition area 140bi may be disposed to overlap under the display module 110 when observed in the z-axis direction. According to an embodiment, the support member 140 may include a part disposition area 140cm, in which a camera sensor (or an image sensor) or at least a portion of a sensor is disposed. The part disposition area 140cm may include a structure, front and rear surfaces of which are passed through. Other components of the first-type portable electronic device 101, in addition to the camera sensor, may also be disposed in the part disposition area 140cm.

At least a portion of the heat dissipation structure 120 may be disposed on the first surface of the support member 140 (e.g., a bottom surface which faces the z-axis direction). As an example, a first portion 120a of the heat dissipation structure 120, which corresponds to an upper end (e.g., a portion in the y-axis direction), may be disposed in the first structure disposition area 140ch1 formed in the support member 140. A second portion 120b of the heat dissipation structure 120, which corresponds to a lower end (e.g., a portion in the -y-axis direction), may be disposed in the second structure disposition area 140ch2 formed in the support member 140. According to an embodiment, front and rear surfaces of the heat dissipation structure 120 may be flat with respect to the z-axis direction, and at least a portion thereof may include a curve or a curved surface. An interior of the heat dissipation structure 120 may include an empty cavity, and at least one of a fluid or a gas may be injected into the empty cavity. One surface of the heat dissipation structure 120 (e.g., a surface which faces the z-axis direction) may face a rear surface of the display module 110 (e.g., a surface which faces the -z-axis direction), or may contact the rear surface of the display module 110. Correspondingly, heat received (or absorbed) by the heat dissipation structure 120 may be diffused and dissipated through a metallic material or another material disposed on the rear surface of the display module 110. The first portion 120a of the heat dissipation structure 120 may face (or contact) a bottom surface of the support member 140 in the z-axis direction (or the first structure disposition area 140ch1), and the second portion 120b of the heat dissipation structure 120 may be disposed in the second structure disposition area 140ch2 of the support member 140 (or a front-and-rear through portion or a through hole). The heat dissipation structure 120 may be formed of a metallic material at least in part, but the disclosure is not limited thereto. As an example, the heat dissipation structure 120 may be formed of a combination of a metal material and a non-metal material, or may be formed of only a non-metal material. As an example, when the heat dissipation structure 120 is positioned in the first structure disposition area 140ch1 and the second structure disposition area 140ch2 of the support member 140, when observed in the z-axis direction (e.g., a direction from a front surface of the display module 110 toward a rear surface thereof), both the first portion 120a and the second portion 120b of the heat dissipation structure 120 may be observed, and when observed in the -z-axis direction (a direction from the rear case 170 toward the display module 110), the first portion 120a of the heat dissipation structure 120 may be covered by a portion of the support member 140, and the second portion 120b may be observed.

A first adhesive member 131 may serve to fix the first portion 120a of the heat dissipation structure 120 to the first structure disposition area 140ch1. As an example, the first adhesive member 131 may include a double-sided tape or a sheet, opposite surfaces of which are applied with an adhesive material. A central portion of the first adhesive member 131 may be empty such that at least a portion of one periphery (e.g., the y-axis periphery) of the first portion 120a is attached to a bottom surface of the first structure disposition area 140ch1, and the first adhesive member 131 may have a shape which is similar to a shape of a periphery of the first portion 120a. As an example, the first adhesive member 131 may be provided in a band shape such that one side (e.g., the y-axis periphery) of the first portion 120a of the heat dissipation structure 120 is allowed to directly contact the first structure disposition area 140ch1, or to be proximate to a bottom surface of the first structure disposition area 140ch1. According to an embodiment, at least one heat emitting element (e.g., an AP) of the printed circuit boards 181 and 182 may be disposed on an opposite surface (e.g., a surface of a portion of a surface of the support member 140, which faces the -z-axis) of the first structure disposition area 140ch1, on which the first adhesive member 131 is disposed.

A second adhesive member 132 may adhere at least a portion of the second portion 120b of the heat dissipation structure 120 and at least a portion of the support member 140 which forms the second structure disposition area 140ch2, such that the second portion 120b of the heat dissipation structure 120 is fixed to the second structure disposition area 140ch2 of the support member 140, or the second portion 120b of the heat dissipation structure 120 is positioned on one surface (e.g., a surface which faces the z-axis direction) of the support member 140. As an example, the second adhesive member 132 may have a band shape which faces a periphery (e.g., an edge) of the second portion 120b of the heat dissipation structure 120, may be provided in a form of a sheet, which is a form of a double-sided tape or opposite surfaces of which are applied with an adhesive material, and the second portion 120b of the heat dissipation structure 120 may be adhered to one side of the support member 140 which forms a periphery of the second structure disposition area 140ch2. According to an embodiment, at least a portion of the second adhesive member 132 may include at least one of two adhesive lines, an adhesive bead, or an adhesive tape, which are formed along a periphery of the second portion 120b of the heat dissipation structure 120. A periphery of a portion of the support member 140 which forms the second structure disposition area 140ch2 may be formed to be stepped, so that the second adhesive member 132 is allowed to be disposed thereon.

According to an embodiment, at least one of a hardware processor, a memory, or an interface may be mounted on the printed circuit boards 181 and 182. For example, the processor may include one or more of a central processing unit, an application processor, a graphic processing device, an image signal processor, a sensor hub processor, or a communication processor. The memory may include, for example, a volatile memory or a nonvolatile memory. The interface may include, for example, a high definition multimedia interface (HDMI), a universal serial bus (USB) interface, a secure digital (SD) card interface, and/or an audio interface. The interface may electrically or physically connect, for example, the first-type electronic device 101 to an external electronic device and may include a USB connector, an SD card/MMC connector, or an audio connector. Although the printed circuit boards 181 and 182 are illustrated as being separated from each other, the printed circuit boards 181 and 182 may be configured to be connected as a single unit, and, in relation to the connection, the first type portable electronic device 101 may include at least one additional structure (e.g., a flexible PCB).

According to an embodiment, various electronic components (or passive elements or active elements) included in the printed circuit boards 181 and 182 may generate heat during operation. At least a portion of the heat generated from the electronic components may be dissipated through the support member 140. According to an embodiment, heat generated from the printed circuit boards 181 and 182 (or heat generated from at least one electronic component disposed on the printed circuit boards 181 and 182) may be dissipated through the heat dissipation structure 120. As an example, the first type portable electronic device 101 may include a heat transfer member (e.g., a TIM (thermal interface material), a mesh-type metal member, or a heat transfer tape) which is capable of transferring heat between the support member 140 and at least one electronic component (or the printed circuit boards 181 and 182). As an example, heat generated from the printed circuit boards 181 and 182 (or electronic components disposed on the printed circuit boards 181 and 182) may be transferred and spread through the support member 140 and/or the heat dissipation structure 120. Additionally or alternatively, heat generated from the electronic components (or the printed circuit boards 181 and 182, hereinafter described with reference to the electronic components) may be transferred and spread by a heat transfer member between the support member 140 and the heat dissipation structure 120, and the heat generated from and transferred from the electronic components may be spread or dissipated through at least a portion of a peripheral structure (e.g., the display module 110) adjacent to the heat dissipation structure 120.

According to an embodiment, the battery 160 is a device for supplying power to at least one component of the first type portable electronic device 101, and may include, for example, a rechargeable secondary battery or a fuel cell. At least a portion of the battery 160 may be disposed, for example, on a surface of the support member 140 which is substantially in the same direction as the printed circuit boards 181 and 182 (e.g., a surface of the support member 140 which faces the -z-axis). The battery 160 may be integrally disposed inside the first type portable electronic device 101, and may be disposed to be detachable from the first type portable electronic device 101. According to an embodiment, the battery 160 may be adhered to at least a portion of the support member 140 through the first type fixing structure 150. As an example, the support member 140 may include a battery area which is formed in one area in the -z-axis direction and in which the battery 160 is disposed, and the battery 160 may be fixedly disposed in the battery area of the support member 140 through the first-type fixing structure 150. As an example, at least a portion of the battery 160 may be attached to a bottom surface of the battery area of the support member 140 through the first-type fixing structure 150.

The first-type fixing structure 150 may be disposed between the support member 140 and the battery 160. As an example, the first-type fixing structure 150 may be disposed at a position between the support member 140 and the battery 160, which does not overlap the printed circuit boards 181 and 182 when viewed in the z-axis direction (or the -z-axis direction). At least a portion of the first-type fixing structure 150 may adhere the battery 160 to a first surface of the support member 140 (e.g., at least a portion of a bottom surface which faces the -z-axis direction, or the battery area). To prevent the heat dissipation structure 120 and the battery 160 from being adhered to each other, the first-type fixing structure 150 may include a structure in which an adhesive material is removed from a surface which faces the heat dissipation structure 120, or a first mask member 151 (or a masking layer, a first mask part, a first mask layer, a first cover, a first non-contact layer, or a first non-contact structure) is disposed on the adhesive material. As an example, the first-type fixing structure 150 may include an upper surface (or a surface which faces the z-axis direction, a front surface, or a surface which may be referred to as a lower surface depending on a viewing direction) and a lower surface (or a surface which faces the -z-axis direction, a rear surface, or a surface which may be referred to as an upper surface depending on a viewing direction). The upper surface may include an upper adhesive area (or a first adhesive area) which is adhered to one surface of the support member 140, and a non-adhesive area which is not adhered to the heat dissipation structure 120 (e.g., the non-adhesive area formed by a mask member being disposed on the upper adhesive area, or the non-adhesive area formed by the upper adhesive area being penetrated through front and rear surfaces thereof). The lower surface may include a lower adhesive area (or a second adhesive area) which is adhered to one surface of the battery 160.

According to an embodiment, the first-type fixing structure 150 may include a plurality of layers. For example, the first-type fixing structure 150 may include a first structure body 153 (or an inner core portion with an adhesive material or an adhesive tape) and a first mask member 151. Alternatively, the first-type fixing structure 150 may include an inner core portion and a plurality of adhesive layers formed on the inner core portion, and the plurality of adhesive layers may have a structure which is partially removed. The first-type fixing structure 150 may be disposed between a bottom surface of the support member 140 and the battery 160 to remove contact between the heat dissipation structure 120 and the battery 160 while fixing the battery 160, thereby blocking or reducing transfer of heat from the heat dissipation structure 120 to the battery 160. Additionally or alternatively, the first-type fixing structure 150 may include a second mask member 152 (or a second mask part, a second mask layer, a second cover, a second non-contact layer, or a second non-contact structure) configured to prevent a specific sensor (e.g., a fingerprint sensor) disposed in the sensor disposition area 140bi from being adhered to an adhesive material (or an adhesive member). When the first-type fixing structure 150 is disposed in one area of the support member 140 (e.g., an area in which the battery 160 is disposed), the second mask member 152 may be disposed in an area corresponding to the sensor disposition area 140bi. The first mask member 151 and the second mask member 152 may include at least one of a polymer structure, a sponge structure, or a mesh structure. As an example, each of the first mask member 151 and the second mask member 152 may include at least one layer or a plurality of layers. When each of the first mask member 151 and the second mask member 152 includes a plurality of layers, the first mask member 151 and the second mask member 152 may include a stacked structure of a polymer structure and a sponge structure. By the first mask member 151 described above, at least one air gap may be formed in at least a portion between the battery 160 and the heat dissipation structure 120. For example, an air gap may be formed at at least a portion between the first mask member 151 and the second portion 120b of the heat dissipation structure 120.

The rear case 170 may be coupled to the support member 140 from the -z-axis direction toward the z-axis direction. As an example, the rear case 170 may include a bottom surface which is flat on front and rear surfaces and has a size corresponding to at least a portion of a surface of the support member 140 in the -z-axis direction, and at least two side walls which extend from opposite peripheries of the bottom surface (e.g., peripheries in the x-axis and -x-axis directions) toward the z-axis direction with a predetermined angle and height, and may be coupled to the support member 140 while surrounding the -z-axis surface of the support member 140. In a process of coupling the rear case 170 to the support member 140, a coupling means (e.g., a double-sided tape, an adhesive material, or a separate coupling means) may be further used. The rear case 170 may include at least one camera hole which allows at least one camera disposed on the support member 140 to be exposed to an outside. The rear case 170 may be disposed, in a process of being coupled to the support member 140, to face a surface of the battery 160 in the -z-axis direction, and may be disposed to face one surface of the printed circuit boards 181 and 182. The rear case 170 may include at least one layer, and may also include a plurality of layers in relation to rigidity reinforcement, various color expression, or provision of various textures.

Additionally, the first type portable electronic device 101 may include at least one antenna which is disposed between the rear case 170 and the battery 160, or which is disposed on at least a portion of the support member 140. The antenna may include, for example, at least one of a near field communication (NFC) antenna, a wireless charging antenna, a magnetic secure transmission (MST) antenna, or an antenna for supporting various generations of mobile communication. For example, the antenna may perform short-range or long-range communication with an external device, or may wirelessly transmit and receive power necessary for charging. According to an embodiment, an antenna structure may be formed by at least a portion of the support member 140 which is formed of a metal material (e.g., a side bezel structure and/or at least a portion of a bottom surface of the support member 140), or a combination thereof.

As described above, according to an embodiment, the first type portable electronic device 101 may have a structure in which the heat dissipation structure 120 is disposed in the second structure disposition area 140ch2 which is formed to pass through front and rear surfaces (e.g., the z-axis and -z-axis surfaces) of the support member 140, in a process of forming a thickness of the support member 140, in which the battery 160 is disposed, to be thin in relation to slimming or weight reduction. In this regard, the first type portable electronic device 101 may include the first-type fixing structure 150, which allows the battery 160 to be more firmly attached to the battery area of the support member 140, facilitates separation of the battery 160 from the support member 140 during a process of separating the battery 160, and prevents damage, deformation, or cracking of the heat dissipation structure 120.

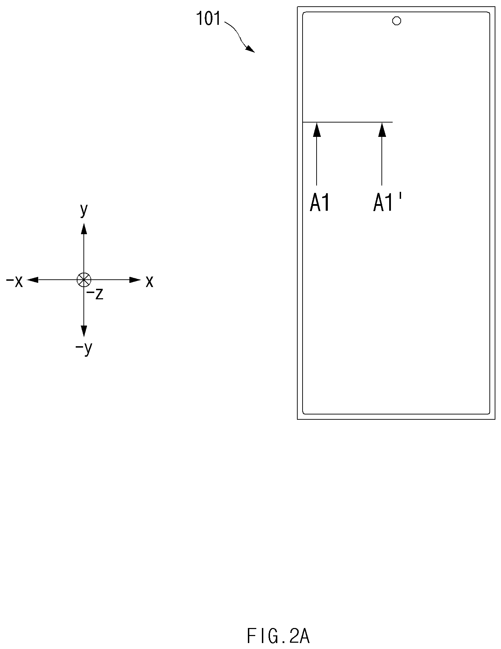

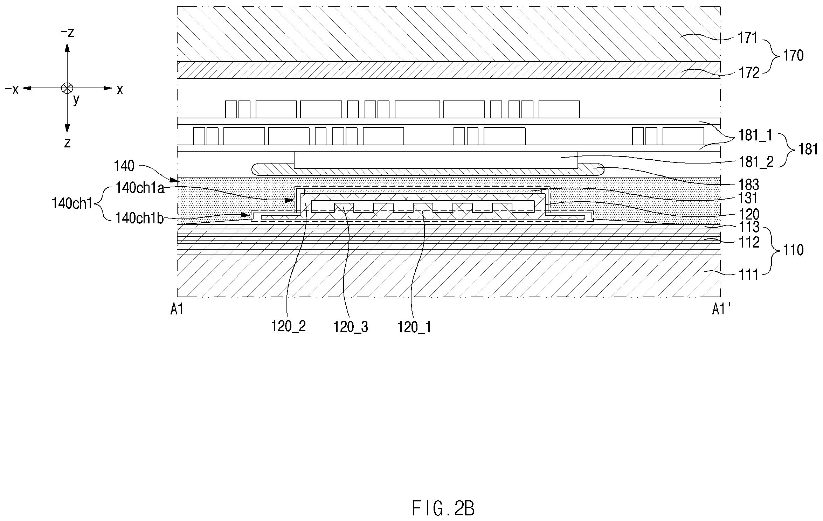

FIGS. 2A and 2B are views illustrating an example of a plan view and a cross-sectional view of a portion of a first-type portable electronic device according to an embodiment. As used hereafter, "FIG. 2" may refer to one or more among FIGS. 2A and 2B.

Referring to FIGS. 1A to 2, at least a portion of a cross section of the first type portable electronic device 101 taken along cutting line A1-A1', as illustrated, may include the display module 110, the support member 140, the first printed circuit board 181, and the rear case 170, from the z-axis direction toward the -z-axis direction. Additionally or alternatively, when the cutting line A1-A1' cuts a partial area including the heat dissipation structure 120, the first type portable electronic device 101 may further include the heat dissipation structure 120 (e.g., the first portion 120a of the heat dissipation structure 120) disposed on one side of the support member 140, and the first adhesive member 131.

The display module 110 may output at least one screen (or image) related to an operation of functions of the first type portable electronic device 101. The display module 110 may include, for example, a window 111, a display panel 112 (or a display), and a sheet 113 (or at least one sheet or a graphite sheet).

The window 111 may include a layer formed of (or including) at least one material selected from a glass material layer, a polymer material layer, and a layer of various other transparent materials through which light is allowed to pass to an extent that a screen displayed on the display panel 112 is observable from an outside (e.g., outside of the electronic device). For example, the display module 110 of the disclosure is not limited to a material of the window 111. Alternatively, depending on a designation, the window 111 may be classified (or defined) as a component which forms an uppermost layer of the display module 110. Additionally or alternatively, the display module 110 may further include at least one of a polarization layer, a protective layer, or an adhesive layer.

According to an embodiment, the display panel 112 may include a structure in which a plurality of pixels capable of implementing a screen according to an operation of a portable electronic device are disposed in a matrix form. As an example, the display panel 112 may include at least one of a liquid crystal display panel, an organic light emitting diode (OLED) panel, or a quantum dot panel, but the display module 110 of the disclosure is not limited to a panel of a specific type or a panel of a specific driving method.

The sheet 113 may include at least one of various material sheets, such as a sheet (or a layer) of a material having a predetermined rigidity for supporting the display panel 112, a sheet (or a layer) of a material related to shock absorption, or a sheet (or a layer) of a material for waterproofing or dustproofing. The sheet 113 may be disposed on a rear surface of the display panel 112 (e.g., a surface opposite to a front surface on which a screen is displayed), and various types of perforations may be applied according to sensor arrangement of the first type portable electronic device 101. As an example, the sheet 113 may include at least one hole area having a size and a position corresponding to at least one of a size and a position of the sensor disposition area 140bi of the support member 140, a hole area having a size and a position corresponding to at least one of a size and a position of a front camera disposition area, and a hole area having at least one size and position corresponding to a size and a position of an area in which a proximity sensor or an illuminance sensor is disposed. The hole area may defined by portions which constitute the sheet 113. By the hole areas which are defined in the sheet 113, at least a portion of a rear surface of the display panel 112 may be exposed in a rearward direction, and light transmitted through the hole areas of the sheet 113 (e.g., light introduced from outside the window 111 or from a surface of the window 111 toward the display panel 112) may be delivered to a corresponding sensor. An area (e.g., a planar area) of the display panel 112 corresponding to at least one area of the hole areas of the sheet 113 may include an area in which pixels are removed, or may include pixels distributed with a density different from a density of surrounding pixels. Additionally or alternatively, the display module 110 may be configured to include only the window 111 and the display panel 112, with the sheet 113 being removed.

The heat dissipation structure 120 may include a structure in which a size in an xy plane is formed to be greater than size in a z-axis height (or direction), and in which an empty space is formed therein. As an example, cross section A1-A1' of the heat dissipation structure 120, as illustrated, may include a heat dissipation substrate 120_1, a heat dissipation cover 120_2 disposed on the heat dissipation substrate 120_1, and a convexo-concave structure 120_3 disposed in an empty space (or a closed space) between the heat dissipation substrate 120_1 and the heat dissipation cover 120_2. As an example, a fluid which is disposed together with the convexo-concave structure 120_3 may be disposed in an empty space between the heat dissipation substrate 120_1 and the heat dissipation cover 120_2, or the empty space may be maintained in an empty state. The convexo-concave structure 120_3 may form a passage through which a fluid is allowed to flow within the empty space. Although the convexo-concave structure 120_3 is illustrated as being spaced apart from an upper end of the heat dissipation cover 120_2 (e.g., a portion in the -z-axis direction, or a lower end when a viewing point is along the z-axis), the disclosure is not limited thereto. For example, at least a portion of an upper end of the convexo-concave structure 120_3 (or a lower end when a viewing reference is along the z-axis) and an inner side of an upper end of the heat dissipation cover 120_2 may be in contact with each other. The heat dissipation substrate 120_1 and the heat dissipation cover 120_2 may be integrated with each other, or may be components bonded to each other in relation to formation of the empty space. An x-axis length of the heat dissipation substrate 120_1 may be formed to be greater than an x-axis length of the heat dissipation cover 120_2. An upper end of the heat dissipation cover 120_2 (e.g., a portion or a surface which faces the -z-axis direction) may be adhered to the support member 140 through the first adhesive member 131 (or a heat dissipation tape, or a member having adhesive performance while being capable of heat transfer). The heat dissipation substrate 120_1 may be disposed in a first structure area 140ch1a (or a first disposition space) of the first structure disposition area 140ch1 of the support member 140, and the heat dissipation cover 120_2 may be disposed in a second structure area 140chlb (or a second disposition space) of the first structure disposition area 140ch1 of the support member 140. The heat dissipation structure 120 located on the cross section along cutting line A1-A1' may correspond to a portion of the first portion 120a.

The support member 140 may have the same structure as the support member 140 described above with reference to FIGS. 1C and 2. As an example, the support member 140 may include at least the first structure disposition area 140ch1. The first structure disposition area 140ch1 may include a first structure area 140chla in which the heat dissipation substrate 120_1 of the heat dissipation structure 120 is disposed, and a second structure area 140chlb in which the heat dissipation cover 120_2 of the heat dissipation structure 120 is disposed. The first structure area 140ch1a and the second structure area 140ch1b may include a groove shape or an empty space in a groove shape, at least portions of the first structure area 140ch1a and the second structure area 140ch1b may be connected to each other, and an x-axis length of the first structure area 140chla may be formed to be greater than an x-axis length of the second structure area 140chlb. According to an embodiment, a -z-axis cross section of the support member 140 (or cross section A1-A1', a cross section from a front direction of the display module 110 toward the rear case 170) corresponding to the first structure disposition area 140ch1 may have a stepped shape. Portions of opposite peripheries (e.g., peripheries in the x-axis and -x-axis directions) of the heat dissipation substrate 120_1 may be held on a step of the support member 140 which is formed at a periphery of the first structure area 140chla. A shape of at least a portion of the first structure disposition area 140ch1 may be formed to be identical or similar to a shape of at least a portion of the heat dissipation structure 120. According to an embodiment, the support member 140 may be formed to have different thicknesses depending on positions along a planar direction (e.g., along the xy plane). For example, a thickness of the support member 140 at which the second structure area 140ch1b is located may be formed to be thinner than a surrounding portion. Alternatively, the support member 140 at a position where the first structure area 140chla and the second structure area 140ch1b overlap (or at a position at which the heat dissipation cover 120_2 is disposed) may have a first thickness, the support member 140 at a position of the first structure area 140chla which does not overlap the second structure area 140chlb (or at a position at which the heat dissipation substrate 120_1 excluding a portion on which the heat dissipation cover 120_2 is formed is disposed) may have a second thickness, and the support member 140 in a peripheral area in which the first structure disposition area 140ch1 is not formed (or a peripheral area of a position at which the heat dissipation structure 120 is disposed) may have a third thickness. The first thickness may be formed to be thinner than the second thickness, and the second thickness may be formed to be thinner than the third thickness.

Based on cross section A1-A1' which cuts the first structure disposition area 140ch1, the first printed circuit board 181 may be disposed between the support member 140 and the rear case 170. The first printed circuit board 181 may include, for example, a substrate part 181_1 and electronic components 181_2. Although the substrate part 181_1 is illustrated as having two stacked layers in the drawings, the disclosure is not limited thereto, and the substrate part 181_1 may include a greater number of substrates or may include a single substrate. When the substrate part 181_1 has a structure in which a plurality of substrates are stacked, the substrate part 181_1 may include at least one interposer which supports upper and lower substrates while supporting electrical connection between the substrates. Electronic components 181_2 may be disposed on the plurality of substrates. As an example, at least one electronic component 181_2 may be disposed on at least one portion of a front surface (e.g., a surface which faces the z-axis direction) or a rear surface (e.g., a surface which faces the -z-axis direction) of the substrate part 181_1. Although, in the illustrated drawings, among various electronic components, a single electronic component disposed toward the support member 140 is designated by a reference numeral as the electronic component 181_2, a plurality of electronic components 181_2 may be further disposed on the substrate part 181_1. The electronic component 181_2 may form physical contact with the support member 140 through a heat transfer member 183, or may form a heat transfer route.

The heat transfer member 183 may be disposed between the support member 140 and the electronic component 181_2 (or at least a portion of the first printed circuit board 181, hereinafter described with reference to the electronic component 181_2), and may transfer heat generated from the electronic component 181_2 to the support member 140. The heat transfer member 183 may include, for example, a thermal interface material (TIM). Alternatively, the heat transfer member 183 may include at least one of various members capable of transferring heat to the support member 140, such as a metal member, a mesh member, or a semi-solid type member (e.g., a gel-type member). As an example, the heat transfer member 183 may include one surface which is larger than one surface of the electronic component 181_2 in the z-axis direction. The heat transfer member 183 may further include an adhesive material so as to be fixed between the electronic component 181_2 and the support member 140. As an example, the heat transfer member 183 may further include a core member (or a sheet or a structure) capable of transferring heat, and an adhesive material which is applied (or disposed) on at least one of one surface of the core member in the -z-axis direction or one surface of the core member in the z-axis direction. When the heat transfer member 183 includes an adhesive material, the adhesive material may have a property of transferring heat together with an adhesive function. At least one of a size and a position of an area of the support member 140, in which the heat transfer member 183 is disposed, may correspond to at least one of a size and a position of an area, in which the heat dissipation structure 120 is disposed (or may be identical or similar to at least one thereof).

The rear case 170 may include a single layer or may include a plurality of layers. As an example, the rear case 170 may include a first plate 171 and a second plate 172. The first plate 171 may be formed of a transparent material (e.g., a glass material). The second plate 172 may be formed of, for example, an MFC material. The first plate 171 and the second plate 172 may be formed of the same material. The rear case 170 may be coupled to the support member 140 to form a space, in which the first type portable electronic device 101 may be formed, in an interior thereof.

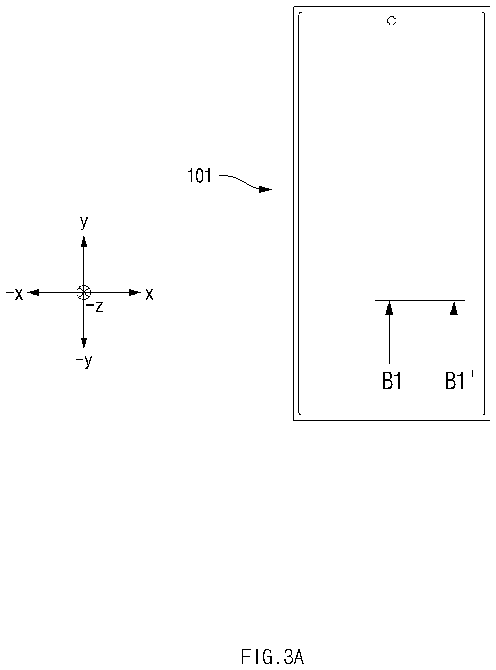

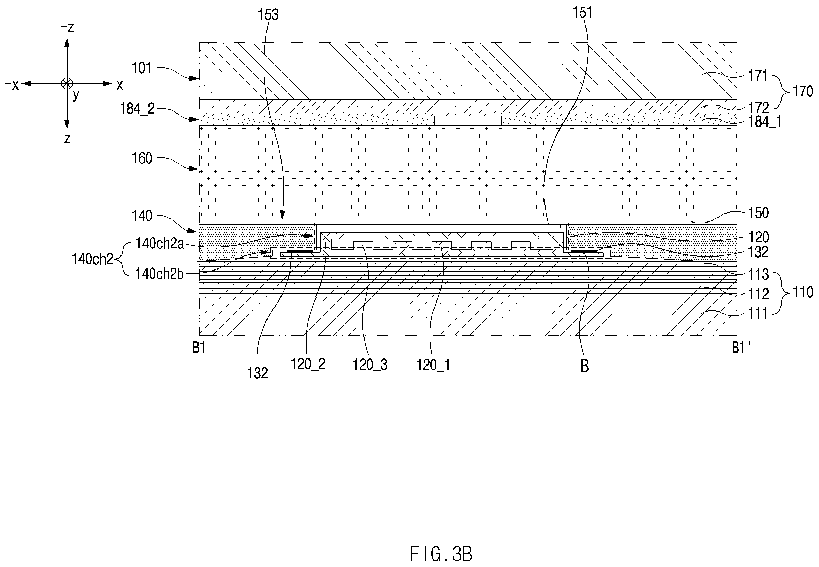

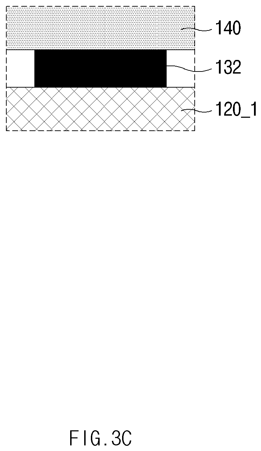

FIGS. 3A, 3B and 3C are views illustrating an example of a plan view and cross-sectional views of a portion of a first-type portable electronic device according to an embodiment. FIG. 3B is a view illustrating an enlarged cross-section of region B indicated in FIG. 3B. As used hereafter, "FIG. 3" may refer to one or more among FIGS. 3A, 3B and 3C.

Referring to FIGS. 1A to 3, at least a portion of a cross section taken along cutting line B1-B1' of the first type portable electronic device 101, as illustrated, may include the display module 110, the support member 140, the battery 160, and the rear case 170, with respect to the z-axis direction toward the -z-axis direction. Additionally or alternatively, when cutting line B1-B1' cuts a partial area including the heat dissipation structure 120, the first type portable electronic device 101 may further include the heat dissipation structure 120 (e.g., the second portion 120b of the heat dissipation structure 120) which is disposed on one side of the support member 140, and the first-type fixing structure 150. Additionally or alternatively, when cutting line B1-B1' cuts a partial area of the battery 160, the first type portable electronic device 101 may further include at least one flexible printed circuit board 184_1 and 184_2 (e.g., an FPCB) which connects the first printed circuit board 181 and the second printed circuit board 182. According to an embodiment, the flexible printed circuit boards 184_1 and 184_2 are components which connect an upper end and a lower end of the first type portable electronic device 101, and may be disposed to connect electronic components other than the printed circuit boards 181 and 182. Although a structure in which two flexible printed circuit boards 184_1 and 184_2 are disposed is illustrated in the drawings, the disclosure is not limited thereto. For example, the first type portable electronic device 101 may include one flexible printed circuit board or three or more flexible printed circuit boards.

At least one of the display module 110, the heat dissipation structure 120, or the rear case 170 illustrated in cross section B1-B1' may have the same structure or configuration as the display module and the rear plate described above with reference to FIG. 2, and thus a detailed description thereof may be replaced with the description provided above.

The support member 140 may include a second structure disposition area 140ch2 which is associated with a first structure disposition area 140ch1. The second structure disposition area 140ch2 may include a shape, in which front and rear surfaces of the support member 140 are passed through. As an example, the second structure disposition area 140ch2 may include a third structure area 140ch2a and a fourth structure area 140ch2b. The third structure area 140ch2a and the fourth structure area 140ch2b may indicate areas in which at least a portion of the support member 140 is removed so that front and rear surfaces are passed through. In the third structure area 140ch2a, a portion of the heat dissipation structure 120 (e.g., a heat dissipation cover 120_2, a convexo-concave structure 120_3, or at least one of a fluid) may be disposed. When viewed in the z-axis direction, another portion of the heat dissipation structure 120 (e.g., a portion of the heat dissipation substrate 120_1) may be disposed in the fourth structure area 140ch2b which partially overlaps the third structure area 140ch2a. The support member 140, on which the third structure area 140ch2a and the fourth structure area 140ch2b are formed, may have a step shape. As an example, the support member 140 in which the fourth structure area 140ch2b is disposed may include first steps which are recessed in the -z-axis direction relative to a peripheral area around a point at which the heat dissipation structure 120 is disposed, and the first steps may be formed on opposite sides of a periphery with respect to the heat dissipation cover 120_2. The second adhesive members 132 may be disposed on the first steps. When viewed in the z-axis direction, the first steps may overlap at least a portion of opposite-side peripheries of the heat dissipation substrate 120_1. An area of the support member 140 in which the third structure area 140ch2a is disposed may be recessed further in the -z-axis direction than areas of the first steps in which a periphery of the heat dissipation substrate 120_1 is disposed, and a hole which is passed through in the -z-axis direction may be formed therein. In a hole area of the support member 140 (e.g., the third structure area 140ch2a), a heat dissipation cover 120_2 and a first mask member 151 included in a first-type fixing structure 150 may be disposed. A gap (e.g., an air gap) may be formed at at least a portion between the heat dissipation structure 120 (e.g., the second portion 120b) and the first mask member 151.

At least a portion of one surface of the battery 160 (e.g., a surface facing the z-axis) may be attached, through the first-type fixing structure 150, to a bottom surface of the support member 140 in the the -z-axis direction. At least a portion of an opposite surface of the battery 160 (e.g., a surface which faces the -z-axis) may be disposed to face the rear case 170, and at least a portion of flexible printed circuit boards 184_1 and 184_2 may be disposed on the opposite surface of the battery 160.

The first-type fixing structure 150 may be disposed between the battery 160 and the support member 140. As an example, the first-type fixing structure 150 may have a size corresponding to one surface of the battery 160, or may have a size smaller than a size of one surface of the battery 160. The first-type fixing structure 150 may have an adhesive material applied to remaining areas, except for an area in which the first mask member 151 is disposed. Alternatively, an adhesive material may be applied to remaining areas of the first-type fixing structure 150, except for an area in which the first mask member 151 which faces the second portion 120b of the heat dissipation structure 120 is disposed. Alternatively, the first mask member 151 may be disposed to cover a portion of the adhesive material of the first structure body 153. An entire one surface of the first-type fixing structure 150 (e.g., a surface which faces the -z-axis direction) may be bonded to one surface of the battery 160, and accordingly, the first-type portable electronic device 101 including the first-type fixing structure 150 may improve a battery fixing force (a force for fixing the battery 160 to a battery area of the first-type portable electronic device 101). Correspondingly, when an operation of removing the battery 160 from the first-type portable electronic device 101 is performed, only the battery 160 may be separated without breakage, damage, or positional deviation of the heat dissipation structure 120.

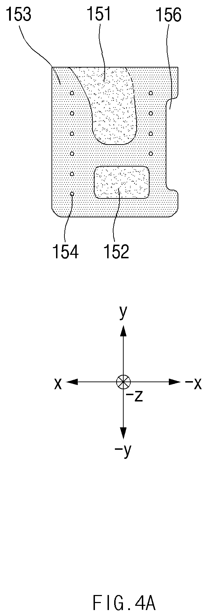

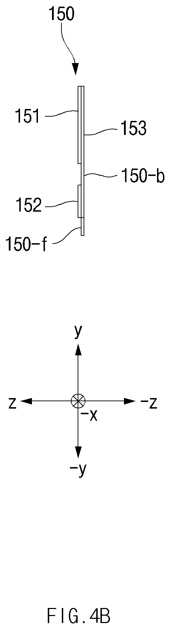

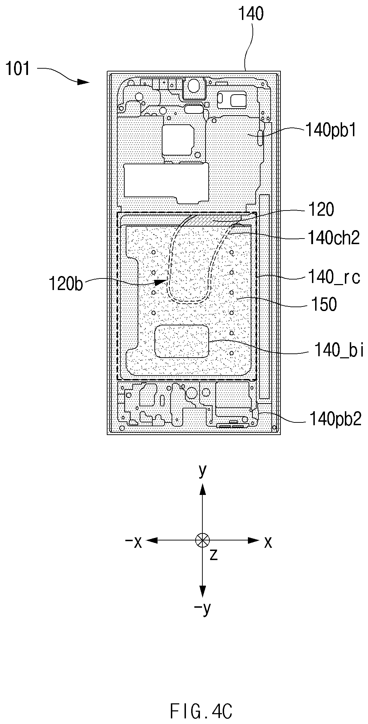

FIGS. 4A, 4B and 4C are views illustrating an example of plan views of a first-type portable electronic device including a first-type fixing structure, a support member, and a heat dissipation structure according to an embodiment. As used hereafter, "FIG. 4" may refer to one or more among FIGS. 4A, 4B and 4C.

Referring to FIGS. 1A to 4, a first-type fixing structure 150 according to an embodiment may include a first structure body 153, a first mask member 151, a second mask member 152, and an auxiliary hole 154. The first-type fixing structure 150 may include an upper surface 150_f (or a surface which faces the z-axis direction, a front surface of the fixing structure, or a front surface of a double-sided adhesive member) and a lower surface 150_b (or a surface which faces the -z-axis direction, a rear surface of the fixing structure, or a rear surface of the double-sided adhesive member). A front surface of the first structure body 153 and front surfaces of the first and second mask members 151 and 152 may be disposed on the upper surface 150_f. A rear surface of the first structure body 153 may be disposed on the lower surface 150_b. At least a portion of the upper surface 150_f (an upper adhesive area or a first adhesive area, in which the first and second mask members 151 and 152 are not formed) may be adhered to one surface of the support member 140. A non-adhesive area of the upper surface 150_f (e.g., an area in which the first and second mask members 151 and 152 are disposed on the first structure body 153) may be disposed to face the second portion 120b of the heat dissipation structure 120. At least a portion (or an entirety) of the lower surface 150_b may include a lower adhesive area (or a second adhesive area) which is adhered to the battery 160. According to an embodiment, a size of a surface area of the lower adhesive area (or the second adhesive area) may be equal to a sum of a size of a surface area of the non-adhesive area and a size of a surface area of the upper adhesive area (or the first adhesive area).

The first structure body 153 may include a shape (e.g., a planar shape) similar to a shape of one surface of the battery 160 (e.g., a surface which faces the z-axis). As an example, an x-axis length or a y-axis length of the first structure body 153 may be formed to be greater than a z-axis thickness thereof. The first structure body 153 may include at least four peripheries, and as an example, depending on a shape of the battery 160, a length in the y-axis direction may be formed to be greater than a length in the x-axis direction. When a shape of the battery 160 is changed, a shape of the first structure body 153 may be changed. At least a portion of four corners at which four peripheries of the first structure body 153 meet may be rounded. As an example, one side periphery of the first structure body 153 (e.g., a -x-axis periphery) may include a handle groove 156 (e.g., a groove in which a battery disassembly structure or a battery disassembly tape is placed, or a handle opening) which has at least a portion removed toward an inner central direction. The handle groove 156 may be omitted. When the handle groove 156 is omitted, as illustrated in FIG. 1C, a portion of the first structure body 153 may be disposed in a handle groove area 156. An adhesive material may be applied to an entirety of a front surface and a rear surface of the first structure body 153. Alternatively, the first structure body 153 may be formed of a double-sided adhesive tape having front and rear surfaces which are adhesive.

The first mask member 151 may include a shape corresponding to a shape of at least a portion of the heat dissipation structure 120 (e.g., the second portion 120b). As an example, when the second portion 120b of the heat dissipation structure 120 is provided in a shape in which a length in the -y-axis direction from the y-axis is greater than a length in the x-axis direction, and when at least a portion of the second portion 120b forms a curved surface which is curved in the -y-axis direction from the y-axis, the first mask member 151 may include a curved surface which is curved at least partially to correspond to a shape of the second portion 120b, and a length of at least a portion of the first mask member 151 in the -y-axis direction may be formed to be greater than a length thereof in another direction. As an example, the first mask member 151 may be disposed on an upper surface of the first structure body 153 (e.g., a surface which faces the z-axis direction, or a front surface). Alternatively, the first mask member 151 may be disposed between the heat dissipation structure 120 (or the second portion 120b of the heat dissipation structure 120) and the first structure body 153 (or the battery 160). Front and rear surfaces of the first mask member 151 may be formed of a non-adhesive material. As an example, one surface (or a front surface) of the first mask member 151 may be adhered to the first structure body 153, and an opposite surface (or a rear surface) of the first mask member 151 may be disposed to face the heat dissipation structure 120 (e.g., the second portion 120b). As an example, one surface of the first mask member 151 which faces the first structure body 153 may include an adhesive material, and an opposite surface which faces the heat dissipation structure 120 may include a non-adhesive material. The first mask member 151 may include at least one layer. As an example, the first mask member 151 may include at least one of a polymer, a sponge, or a mesh structure. Alternatively, the first mask member 151 may be formed of a semi-solid type material (e.g., a gel-type material). The first mask member 151 may prevent or reduce breakage of the heat dissipation structure 120 when the battery 160 is disassembled, and may block at least a portion of heat of the heat dissipation structure 120 (or a heat dissipation member) from being transferred to the battery 160.

The second mask member 152 may include a shape corresponding to a shape of a sensor (e.g., a biometric sensor) disposed under the display module 110 of the first-type portable electronic device 101. As an example, when the sensor has a rectangular shape, the second mask member 152 may include a rectangular shape corresponding to the shape of the sensor. As an example, the second mask member 152 may be disposed on an upper surface of the first structure body 153 (e.g., a surface which faces the z-axis direction, or a front surface) which does not overlap the first mask member 151. Accordingly, the first mask member 151 and the second mask member 152 may be disposed on the same surface of the first structure body 153. The second mask member 152 may be disposed between the biometric sensor and the first structure body 153 (or the battery 160). Front and rear surfaces of the second mask member 152 may be formed of a non-adhesive material. As an example, one surface of the second mask member 152 may be adhered to the first structure body 153 which does not overlap the first mask member 151 when viewed in the z-axis direction, and an opposite surface of the second mask member 152 may be disposed to face a sensor disposition area 140bi (i.e., to face toward the sensor disposition area 140bi). The second mask member 152 may be formed of the same material as the first mask member 151. Alternatively, the second mask member 152 may be formed of a material different from that of the first mask member 151. The second mask member 152 may include a single layer or a plurality of layers, and may have the same number of layers as the first mask member 151, or may be configured differently. According to an embodiment, at least one of the first mask member 151 or the second mask member 152 may include a plurality of layers having different types of materials.

Meanwhile, although a structure in which the first-type fixing structure 150 includes the second mask member 152 has been described above as an example, the disclosure is not limited thereto. As an example, the first-type portable electronic device 101 may not include a sensor at a position under the display module 110. For example, the second mask member 152 may be excluded from the first-type fixing structure 150. Similarly, a sensor disposition area 140bi (a hole area) for sensor arrangement may be removed from a battery area 140_rc of the support member 140, and a portion of the support member formed of a metallic material or an injection-molded material may be disposed to fill the sensor disposition area 140bi.

The auxiliary hole 154 may be formed to pass through front and rear surfaces of the first structure body 153 (e.g., surfaces which face the z-axis and the -z-axis). As an example, a plurality of auxiliary holes 154 may be disposed at regular intervals. As an example, the auxiliary holes 154 may include a plurality of holes, the plurality of holes may be divided into pairs each including two holes, and holes belonging to one pair may be connected to each other through a cutaway portion or a gap which cuts through front and rear surfaces of the first structure body 153. A plurality of auxiliary holes 154 may be disposed on one side of the first structure body 153 on which the first mask member 151 and the second mask member 152 are not formed. As an example, the auxiliary holes 154 may include a structure in which holes spaced apart from each other at regular intervals in the y-axis direction are arranged to form a row. The auxiliary holes 154 may serve as passages which guide a flow of air in front and rear surface directions while the first-type fixing structure 150 is disposed in the battery area 140_rc of the support member 140, thereby supporting the first-type fixing structure 150 to be adhered to the battery area 140_rc without generation of bubbles. Furthermore, the auxiliary holes 154 may support the battery 160 to be adhered onto the first-type fixing structure 150 without generation of bubbles while the battery 160 is adhered to the first-type fixing structure 150. The auxiliary holes 154 may be omitted.

The support member 140 may include a first board area 140pb1, a second board area 140pb2, and a battery area 140_rc, which are disposed on one surface in the -z-axis direction. At least a portion of the first printed circuit board 181 may be positioned in the first board area 140pb1, and at least a portion of the second printed circuit board 182 may be positioned in the second board area 140pb2. Additionally or alternatively, at least a portion of another hardware component related to a user function of the first-type portable electronic device 101 may be disposed in the first board area 140pb1 and the second board area 140pb2. On one surface of the support member 140 which faces the z-axis direction, the heat dissipation structure 120 and the display module 110 may be disposed as described above. The second portion 120b of the heat dissipation structure 120 may be disposed in a through part (or a hole area, or a second structure disposition area 140ch2) which passes through front and rear surfaces of the support member 140. The battery area 140_rc may be disposed between the first board area 140pb1 and the second board area 140pb2. As an example, the battery area 140_rc may include at least one sidewall of the support member 140 which is formed at a periphery of the battery area 140_rc and protrudes from the z-axis toward the -z-axis direction. A second structure disposition area 140ch2 in which the second portion 120b of the heat dissipation structure 120 is disposed may be formed in the battery area 140_rc. As an example, the second structure disposition area 140ch2 described above may be formed by removing a portion of the battery area 140_rc. As an example, a sensor disposition area 140bi in which a sensor (e.g., a biometric sensor) is disposed may be formed in the battery area 140_rc. The sensor disposition area 140bi may be omitted when the first-type portable electronic device 101 does not include a specific sensor.

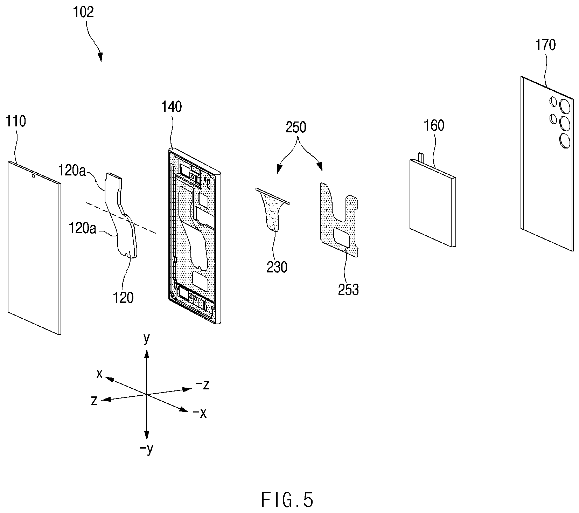

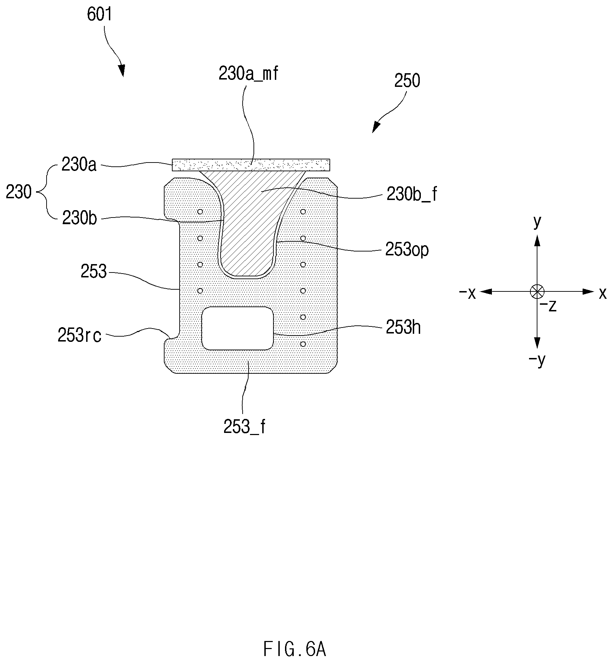

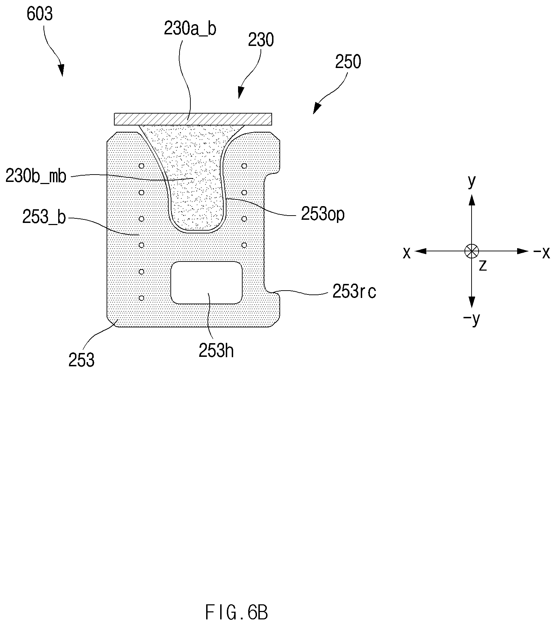

FIG. 5 is a view illustrating an exploded perspective view of a second-type portable electronic device according to an embodiment. FIGS. 6A and 6B are views illustrating an example of a second-type fixing structure and a third mask member according to an embodiment. As used hereafter, "FIG. 6" may refer to one or more among FIGS. 6A and 6B.

The second-type portable electronic device 102 may include at least some components of the portable electronic device 400 described above with reference to FIGS. 1A and 1B.

Referring to FIGS. 1A to 5, a second-type portable electronic device 102 may include a support member 140 (e.g., a bracket, a frame, or a housing), a display module 110 (or a display assembly, a display structure, or a display assembly) (e.g., a structure including the front plate 402 and the display 401 of FIGS. 1A and 1B), a battery 160, and a rear case 170 (e.g., the rear plate 411 of FIGS. 1A and 1B, and the rear case 170 of FIG. 1C). According to an embodiment, the second-type portable electronic device 102 may include a heat dissipation structure 120, at least a portion of which is disposed between the support member 140 and the display module 110, and a second-type fixing structure 250 (e.g., a third mask member 230 and a second structure body 253) (or a second battery fixing structure, a second battery adhesive structure, a second adhesive structure, or a second adhesive member) disposed between the support member 140 and the battery 160.

Additionally or alternatively, the second-type portable electronic device 102 may include at least one of the printed circuit boards 181 and 182 described above with reference to FIG. 1C. Furthermore, according to an embodiment, the second-type portable electronic device 102 may include the first and second adhesive members 131 and 132 for fixing the heat dissipation structure 120 to one side of the support member 140, as described above in the process of describing the first-type portable electronic device 101.

In the configuration of the second-type portable electronic device 102 described above, the display module 110, the heat dissipation structure 120, the support member 140, the battery 160, and the rear case 170 may have the same or similar configurations as the display module, the heat dissipation structure, the support member, the battery, and the rear case described above with reference to the first-type portable electronic device 101, and thus, detailed descriptions thereof may be replaced by the descriptions provided above.

The second structure body 253 may be disposed between the support member 140 and the battery 160. The second-type fixing structure 250 may be partially cut away or removed so as to be disposed not to overlap the third mask member 230 when viewed in the z-axis direction. Alternatively, at least a portion of an area of the second-type fixing structure 250 which surrounds the third mask member 230 may be disposed to overlap a peripheral portion of the third mask member 230.

In FIG. 6, state 601 illustrates an example of a state in which the third mask member 230 and the second-type fixing structure 250 are positioned on the support member 140, as viewed in a direction in which the battery 160 is disposed (or a direction from the -z-axis toward the z-axis). In FIG. 6, state 603 illustrates an example of a state in which the third mask member 230 and the second-type fixing structure 250 are positioned on the support member 140, as viewed in a direction in which the display module 110 (or the heat dissipation structure 120) is disposed on the support member 140 (or a direction from the z-axis toward the -z-axis).

Referring to state 601 and state 603, the second structure body 253 may include a front body 253_f and a rear body 253_b. The front body 253_f and the rear body 253_b of the second structure body 253 may include the same structure and shape. As an example, an adhesive material may be applied (or disposed) on an entirety of the front body 253_f and the rear body 253_b, or on portions thereof. As an example, at least a portion (or an entire surface) of the rear body 253_b may be adhered to a bottom surface of the support member 140. At least a portion (or an entire surface) of the front body 253_f of the second structure body 253 may be adhered to a front surface of the battery 160 (e.g., a surface of the battery 160 which faces the z-axis direction).

The second structure body 253 may include four peripheries, and may include a handle groove 253rc disposed on one side periphery (e.g., a periphery in the -x-axis direction) (e.g., the same configuration as the handle groove 156 of FIG. 4), a first opening 253op disposed on a periphery in the y-axis direction, and a sensor hole 253h which is offset toward the -y direction and is formed to pass through front and rear surfaces thereof. According to an embodiment, the sensor hole 253h may be excluded from the second structure body 253, and a sensor hole area 253h may be filled by the front body 253_f and the rear body 253_b to which an adhesive material is applied. The second structure body 253, in which a sensor hole area 253h is excluded and the corresponding area (the sensor hole area) is filled with an adhesive material, may be applied even when the second-type portable electronic device 102 includes a sensor (e.g., a biometric sensor). Meanwhile, a one-side periphery in which the handle groove 253rc is disposed is for facilitating disassembly of the battery 160, and may be replaced with an opposite-side periphery of the second structure body 253 (e.g., a periphery in the x-axis direction), or may be excluded. Alternatively, a handle groove 253rc may be formed at at least one of opposite peripheries (e.g., the -x-axis periphery and the x-axis periphery). The second structure body 253 may include at least one auxiliary hole which passes through front and rear surfaces thereof (e.g., the auxiliary hole 154 described with reference to FIG. 4).

The third mask member 230 may be disposed between the support member 140 and the battery 160. Alternatively, when observed in the z-axis direction in a stacked state of the components of the second-type portable electronic device 102, a portion of the third mask member 230 may be adhered to one surface of the support member 140 in the -z-axis direction, and another portion of the third mask member 230 may be disposed between the support member 140, on which the heat dissipation structure 120 is disposed (or the second portion 120b of the heat dissipation structure 120) and the battery 160. In this regard, the third mask member 230 may include a first mask upper member 230a and a first mask lower member 230b. The first mask upper member 230a may include a first mask upper end front surface 230a_mf, to which an adhesive material is not applied (or in which an adhesive member is not disposed), and a first mask upper end rear surface 230a_b, to which an adhesive material is applied (or in which an adhesive member is disposed). The first mask lower member 230b may include a first mask lower end front surface 230b_f, to which an adhesive material is applied (or in which an adhesive member is disposed), and a first mask lower end rear surface 230b_mb, to which an adhesive material is not applied (or in which an adhesive member is not disposed).

The first mask upper member 230a may include a bar-type shape, an x-axis length of which is greater than a y-axis length thereof. An x-axis length of the first mask upper member 230a may be formed to be greater than an x-axis length of the first mask lower member 230b. A y-axis length of the first mask upper member 230a may be formed to be shorter than a y-axis length of the first mask lower member 230b.

The first mask lower member 230b may include a structure which extends from one side of the first mask upper member 230a in the -y-axis direction. As an example, at least a portion of a shape of the first mask lower member 230b may include a shape corresponding to a shape of the first opening 253op. As an example, a size of the first mask lower member 230b may be formed to be smaller than a size of the first opening 253op by a specific predefined size, so that, when a second-type fixing structure 250, which includes the third mask member 230 and the second structure body 253, is positioned on the support member 140, a gap having a specific size may be formed between a periphery of the first mask lower member 230b (or a periphery) and a periphery of the second structure body 253 which forms the first opening 253op (or an inner periphery). According to an embodiment, a size of the first mask lower member 230b may be formed to be greater than a size of the first opening 253op by a specific predefined size (e.g., several to several hundred micrometers), so that a periphery of the first mask lower member 230b may have an adhesive state with an inner periphery of the second structure body 253 which forms the first opening 253op.

The second-type portable electronic device 102 described above may provide a structure, in which the heat dissipation structure 120 is positioned on a rear surface of the support member 140 (e.g., a surface in the -z-axis direction), and the third mask member 230 is positioned to cover the second portion 120b of the heat dissipation structure 120, so that the heat dissipation structure 120 and the battery 160 do not directly contact each other. Correspondingly, a gap (or an air gap) may be formed at at least a portion between the second portion 120b of the heat dissipation structure 120 and the third mask member 230.

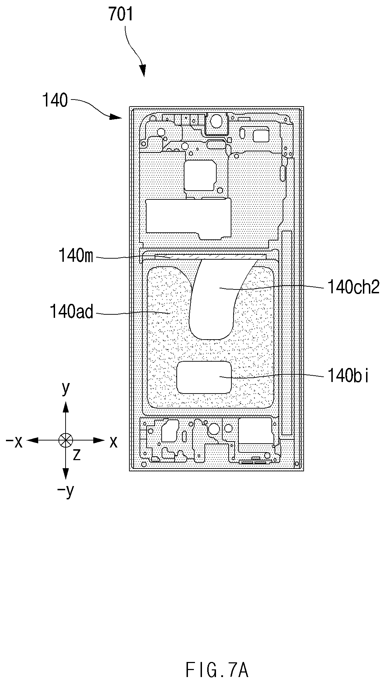

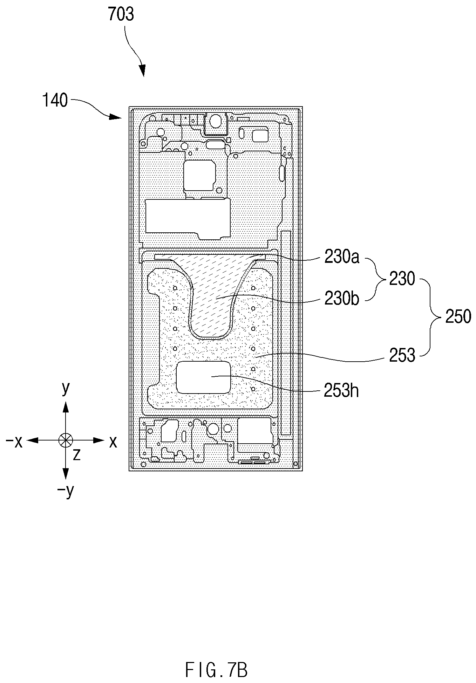

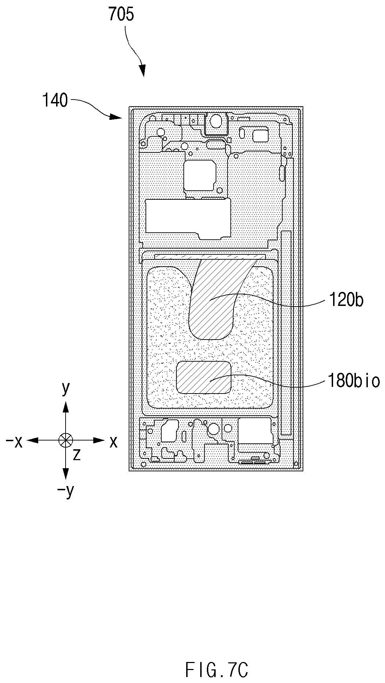

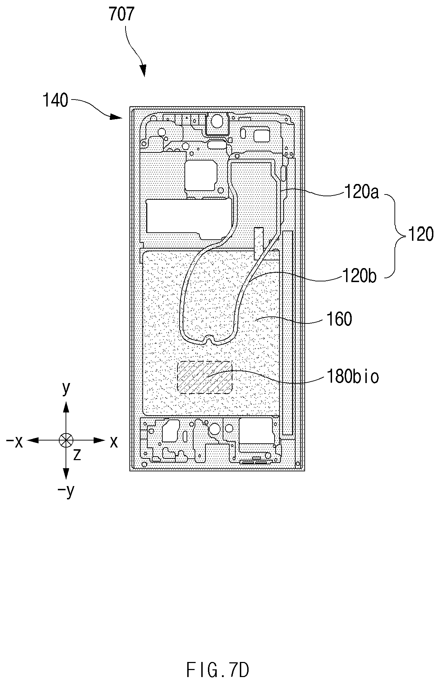

FIGS. 7A, 7B, 7C and 7D are views illustrating plan views of a disposition form of a support member and some peripheral components of a second-type portable electronic device according to an embodiment. As used hereafter, "FIG. 7" may refer to one or more among FIGS. 7A, 7B, 7C and 7D.

Referring to FIGS. 5 to 7, the second-type portable electronic device 102 according to an embodiment may include the support member 140, as in state 701. One surface of the support member 140 (e.g., a surface facing the -z-axis) may include a battery adhesive area 140ad, a sensor disposition area 140bi, a second structure disposition area 140ch2, and a mask adhesive area 140m. The battery adhesive area 140ad may include an area of the second-type fixing structure 250, to which at least a portion of the second structure body 253 is adhered. The sensor disposition area 140bi may include an area, in which a biometric sensor (e.g., a fingerprint sensor) included in the second-type portable electronic device 102 is disposed. The sensor disposition area 140bi may be omitted when the second-type portable electronic device 102 does not include a biometric sensor. When the sensor disposition area 140bi is omitted, a space corresponding to the sensor disposition area 140bi may be filled by a member of a specific material which constitutes the support member 140 (e.g., a metal member). The second structure disposition area 140ch2 may include an area, in which at least a portion of the second portion 120b of the heat dissipation structure 120 is disposed. As described above, the second structure disposition area 140ch2 may include a hole shape, in which front and rear surfaces of the support member 140 are passed through. The mask adhesive area 140m may include an area, to which at least a portion of the third mask member 230 (e.g., the first mask upper member 230a) is adhered.

Referring to state 703, the second-type fixing structure 250 may be disposed on the support member 140. As an example, the first mask upper member 230a of the third mask member 230 may be adhered to the mask adhesive area 140m. The first mask lower member 230b of the third mask member 230 may be disposed in the second structure disposition area 140ch2. The second structure body 253 may be adhered to the battery adhesive area 140ad. The sensor hole 253h, which is formed in the second structure body 253, may be disposed to be aligned with the sensor disposition area 140bi, which is formed in the support member 140. In this regard, the sensor hole 253h and the sensor disposition area 140bi may have a same or similar size and shape.

Referring to states 701, 703, 705 and 707, the second portion 120b of the heat dissipation structure 120 may be disposed in the second structure disposition area 140ch2 of the second-type portable electronic device 102. A rear surface of a sensor 180bi, which is related to biometric sensing of the second-type portable electronic device 102, may be disposed in the sensor disposition area 140bi. The rear surface of the sensor 180bi may include at least one of a substrate which supports the sensor 180bi, a metal plate, and a noise shielding sheet. According to an embodiment, the first portion 120a, which is connected to the second portion 120b of the heat dissipation structure 120, may be disposed at an upper end of the support member 140 (e.g., a portion in the y-axis direction). A front surface of the sensor 180bi may be disposed on one surface of the support member 140 in the z-axis direction. A sensing part which receives light transmitted through the display module 110 may be disposed on a front surface of the sensor 180bi.

The battery 160 may be adhered on the second structure body 253, which is disposed on the battery adhesive area 140ad of the support member 140. The battery 160 may be adhered to the first mask lower member 230b of the third mask member 230 while the battery 160 is positioned on the second structure body 253. Correspondingly, at a lower portion of the battery 160 (e.g., a lower portion when viewed from the -z-axis toward the z-axis, and an upper portion of the battery 160 when viewed from the z-axis toward the -z-axis), a sensor 180bi and a portion of the heat dissipation structure 120 (e.g., the second portion 120b) may be disposed. The third mask member 230 (e.g., the first mask lower member 230b) may be disposed between the second portion 120b of the heat dissipation structure 120 and one area of the battery 160, and an air gap may be formed at at least a portion between the second portion 120b and the third mask member 230. Similarly, an air gap may be formed at at least a portion between the sensor 180bi and the battery 160.

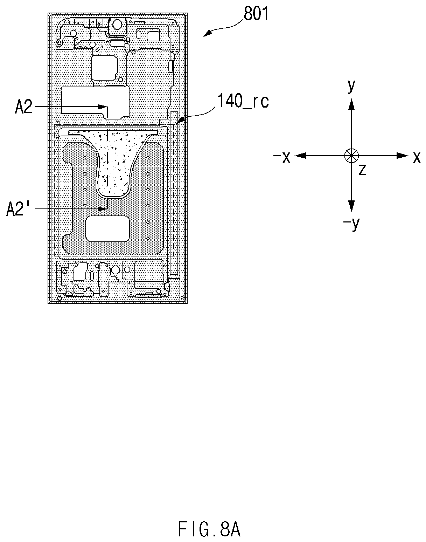

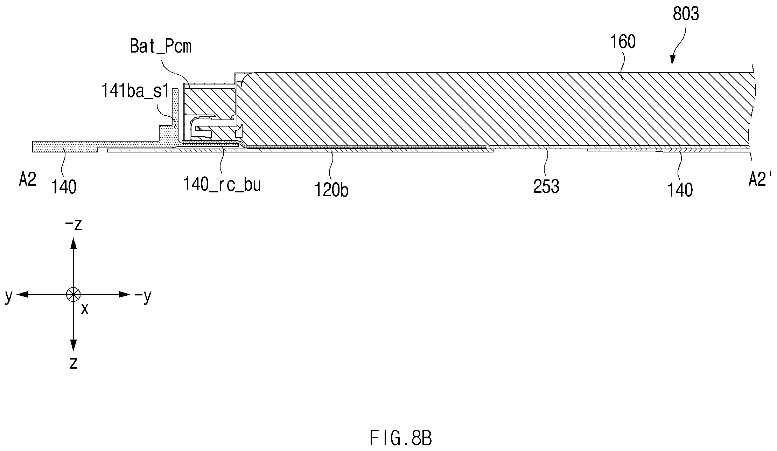

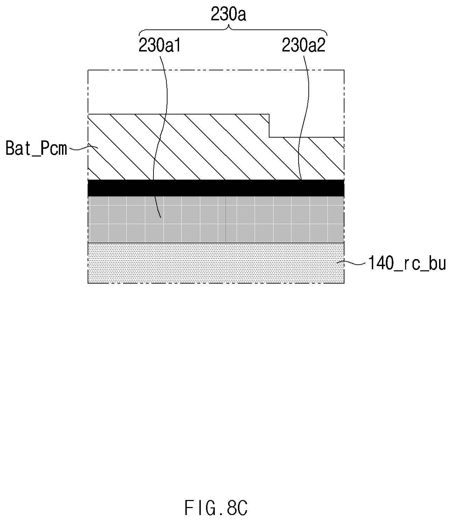

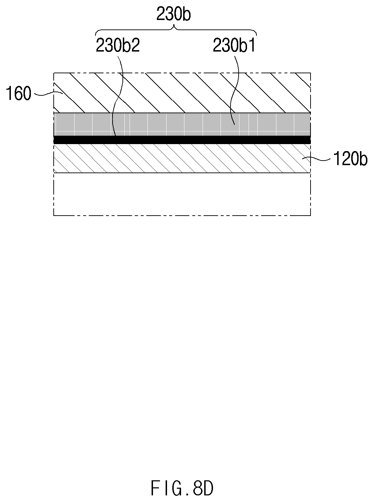

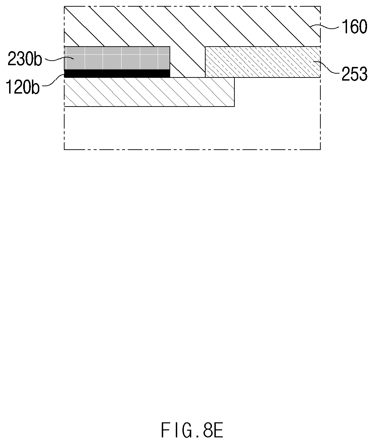

FIGS. 8A, 8B, 8C, 8D and 8E are views illustrating an example of a plan view and cross-sectional views of one side of a support member, with one side thereof cut away, on which a second-type fixing structure is disposed, according to an embodiment. FIGS. 8C, 8D and 8E are views illustrating enlarged cross-sections of regions C, D and E indicated in FIG. 8B, respectively. As used hereafter, "FIG. 8" may refer to one or more among FIGS. 8A, 8B, 8C, 8D and 8E.

Referring to FIGS. 5 to 8, a drawing of state 801, in which cutting line A2-A2' is illustrated, illustrates a state in which the second-type fixing structure 250 and the support member 140 are aligned with each other before the battery 160 is disposed, and a cross-sectional view of state 803, taken along cutting line A2-A2', illustrates a structure which includes the battery 160. The second-type portable electronic device 102 according to an embodiment may partially include the support member 140, the second-type fixing structure 250, and the battery 160. The support member 140 may include a specific area, in which the battery 160 may be disposed (e.g., a battery area 140_rc of FIG. 4), and the battery area 140_rc may include at least one side wall (e.g., a battery upper side wall 141ba_s1). When the second-type portable electronic device 102, which includes some components (e.g., components including the support member 140, the heat dissipation structure 120, and the second-type fixing structure 250), is observed from the z-axis direction toward the -z-axis direction, a front surface (e.g., a surface which faces the z-axis) of the first portion 120a and the second portion 120b of the heat dissipation structure 120 may be observed on one surface of the support member 140 (e.g., a surface which faces the z-axis). A rear surface (e.g., a surface which faces the -z-axis) of the second portion 120b may face one surface of the first mask lower member 230b of the third mask member 230.

According to an embodiment, the first mask upper member 230a of the third mask member 230 may include an upper adhesive layer 230a1 and an upper base layer 230a2, and the first mask lower member 230b may include a lower adhesive layer 230b1 and a lower base layer 230b2. The upper adhesive layer 230a1 may be adhered to an area of the support member 140 (e.g., a partial area 140_rc_bu of the battery area 140_rc of the support member 140). The partial area 140_rc_bu of the support member 140 may include an area, in which at least a portion of a power control module (PCM) Bat_Pcm of the battery 160 is disposed. Alternatively, when viewed in the z-axis direction or the -z-axis direction, the partial area 140_rc_bu and at least a portion of a power control module (PCM) Bat_Pcm of the battery 160 may overlap with each other. The upper base layer 230a2 may be disposed to face at least a portion of a power control module (PCM) Bat_Pcm of the battery 160. The upper base layer 230a2 may include, for example, a sheet, to which the upper adhesive layer 230a1 is applied (or on which an adhesive tape is disposed). The upper base layer 230a2 may be formed of a non-adhesive material. For example, the upper base layer 230a2 may include a polymer material and a plastic material. The upper adhesive layer 230a1 may be disposed on the first mask upper end front surface 230a_mf, and the upper base layer 230a2 may be disposed on the first mask upper end rear surface 230a_b.

The lower adhesive layer 230b1 may be disposed on the first mask lower end rear surface 230b_mb, and the lower base layer 230b2 may be disposed on the first mask lower end front surface 230b_f. The lower base layer 230b2 may be connected to the upper base layer 230a2. The lower base layer 230b2 may have the same material as the upper base layer 230a2. The lower adhesive layer 230b1 may be disposed on one area of the support member 140 (e.g., an area in which the battery 160 is positioned), and, when the battery 160 is disposed, may be adhered to one surface of the battery 160 (e.g., a surface which faces the z-axis). Alternatively, when viewed in the z-axis direction or the -z-axis direction, at least a portion of the lower adhesive layer 230b1 may overlap the battery 160. The lower base layer 230b2 may be disposed to face at least a portion of the second portion 120b of the heat dissipation structure 120. The lower base layer 230b2 may include, for example, a sheet, to which the lower adhesive layer 230b1 is applied (or on which an adhesive tape is disposed). The lower base layer 230b2 may be formed of the same material as or a similar material to the upper base layer 230a2, and may be formed of, for example, a non-adhesive material. The lower adhesive layer 230b1 may be disposed on the first mask lower end rear surface 230b_mb, and the lower base layer 230b2 may be disposed on the first mask lower end front surface 230b_f.

A front surface and a rear surface of the second structure body 253 may be adhered to a bottom surface of the battery area 140_rc of the support member 140 and a front surface of the battery 160, respectively. When viewed in the -z-axis direction, a periphery of the third mask member 230 which is adjacent to the second structure body 253 and a periphery of the second structure body 253 which is adjacent to the third mask member 230 may be disposed so as not to overlap each other. Alternatively, a gap may be formed between a periphery of the third mask member 230 and a periphery of the second structure body 253. A z-axis thickness of the third mask member 230 and a z-axis thickness of the second structure body 253 may be formed to be the same as or similar to each other.

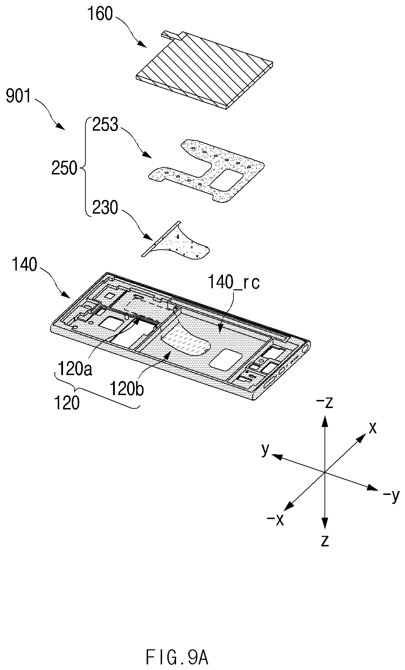

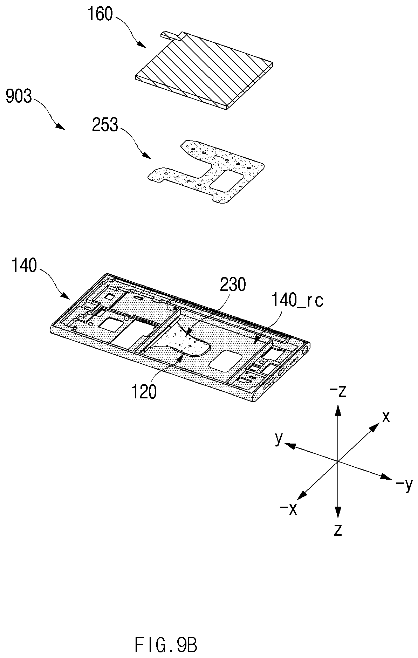

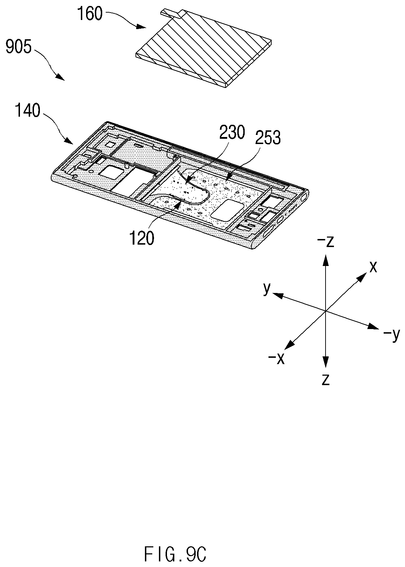

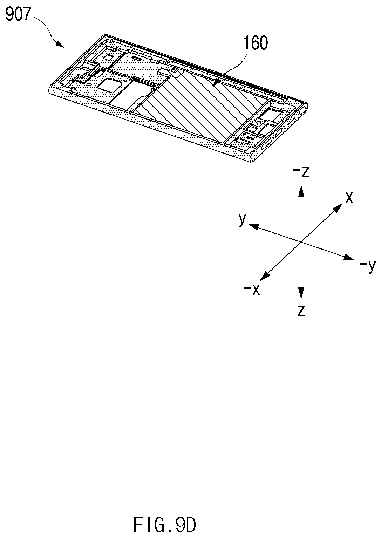

FIGS. 9A, 9B, 9C and 9D are views illustrating an example of an assembly sequence of a second-type portable electronic device according to an embodiment. As used hereafter, "FIG. 9" may refer to one or more among FIGS. 9A, 9B, 9C and 9D.

Referring to FIGS. 5 to 9, as in state 901, the second-type portable electronic device 102 may include at least the support member 140, the heat dissipation structure 120, the second-type fixing structure 250 (e.g., the third mask member 230 and the second structure body 253), and the battery 160. The heat dissipation structure 120 may be positioned on one surface of the support member 140 (e.g., a surface which faces the z-axis direction). In this process, while the second portion 120b of the heat dissipation structure 120 is positioned in the second structure disposition area of the support member 140, front and rear surfaces of which are passed through, a rear surface of the second portion 120b of the heat dissipation structure 120 may be disposed to be exposed in the -z-axis direction of the support member 140.

As in state 903, in a state in which the second portion 120b of the heat dissipation structure 120 is exposed in the -z-axis direction through the second structure disposition area of the support member 140, the third mask member 230 may be positioned on the support member 140 to cover the second portion 120b of the heat dissipation structure 120. In this process, the first mask upper member 230a of the third mask member 230 may be adhered to a portion of a bottom surface of the battery area 140_rc of the support member 140, and the first mask lower member 230b may be disposed to cover the second portion 120b of the heat dissipation structure 120. According to an embodiment, a size of one portion of the first mask lower member 230b (e.g., an x-axis length at one point of the first mask lower member 230b) may be formed to be smaller than a size of the second portion 120b of the heat dissipation structure 120 (or an x-axis length at one point of the second portion 120b). Correspondingly, a width of a specific size of a periphery of the second portion 120b of the heat dissipation structure 120 may be exposed in a band shape in the -z-axis direction. According to an embodiment, a size of a portion of the third mask member 230 (e.g., the first mask lower member 230b) may be formed to be the same as a size of the second portion 120b of the heat dissipation structure 120 (e.g., a portion of the support member 140, which is exposed in the - z-axis direction).

As in state 905, while the third mask member 230 is disposed to cover at least a portion of the second portion 120b of the heat dissipation structure 120, the second structure body 253 may be adhered to a bottom surface of the battery area 140_rc of the support member 140. In this regard, front and rear surfaces of the second structure body 253 may be applied with an adhesive material or may be configured in a form of a double-sided adhesive tape. In the illustrated drawings, the second structure body 253 is illustrated in a form which includes a sensor hole 253h, which corresponds to an area in which the sensor 180bi is disposed, but the disclosure is not limited thereto. For example, the sensor hole 253h of the second structure body 253 may be removed, and an adhesive material (e.g., a first adhesive material disposed on a front surface and a second adhesive material disposed on a rear surface) may be formed on the front and rear surfaces in the same manner as surrounding portions. The second structure body 253 may include a first opening 253op, which has a same size as or a larger size than a portion of the third mask member 230 (e.g., the first mask lower member 230b), so that the third mask member 230 and the second structure body 253 may be disposed on the same plane. Alternatively, the third mask member 230 and the second structure body 253 may be disposed so as not to overlap each other, when observed in the -z-axis direction (or the z-axis direction). Alternatively, when observed in the -z-axis direction, a gap may be formed between a periphery of the first mask lower member 230b of the third mask member 230 and a periphery of the second structure body 253 which forms the first opening 253op. The gap may correspond to a size of the second portion 120b of the heat dissipation structure 120, which is exposed in the - z-axis direction.

As in state 907, while the third mask member 230 and the second structure body 253 are disposed in the battery area 140_rc of the support member 140, the battery 160 may be stacked on the third mask member 230 and the second structure body 253. As an adhesive material is disposed on a surface of the first mask lower member 230b of the third mask member 230 in the -z-axis direction and on a surface of the second structure body 253 in the - z-axis direction, the battery 160 may be more firmly adhered to the third mask member 230 and the second structure body 253. As described above, even when a second structure disposition area for disposing the heat dissipation structure 120 is formed in the support member 140, and a first opening 253op is formed in the second structure body 253, an adhesive extent of the battery 160 may be further secured through the third mask member 230, to which an adhesive material is applied (or in which an adhesive material is disposed), so that movement of the battery 160 may be improved (reduced).

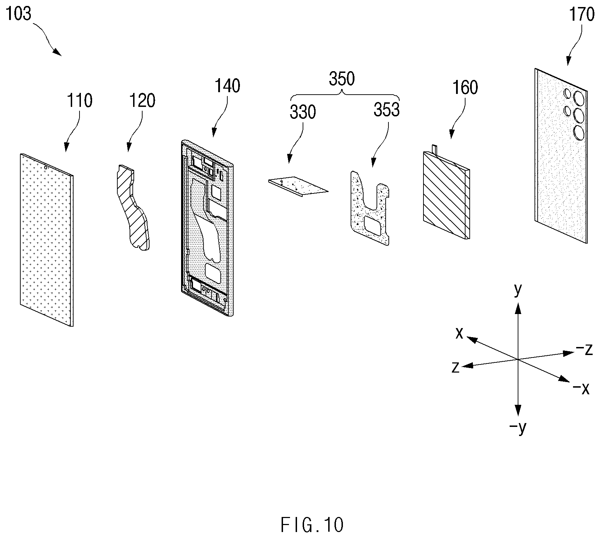

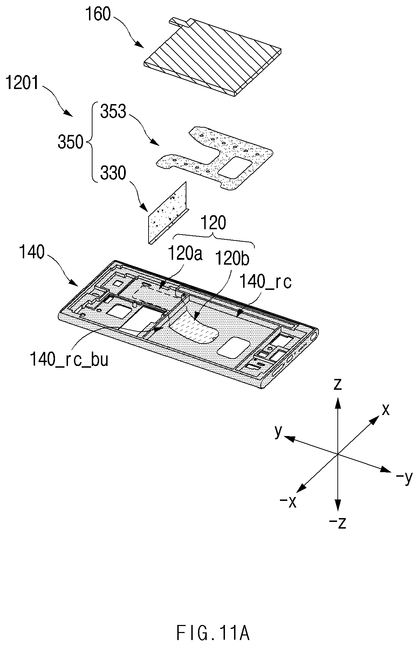

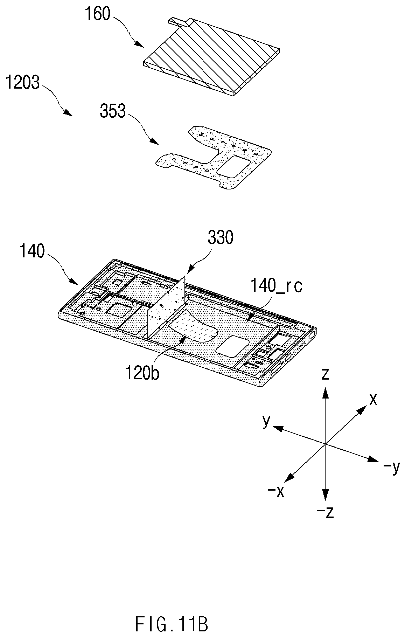

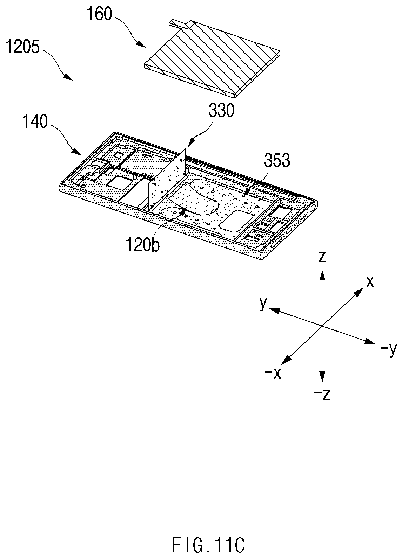

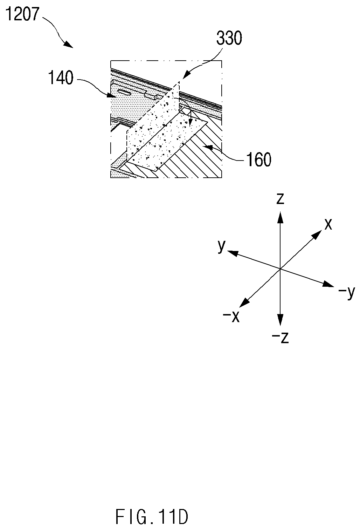

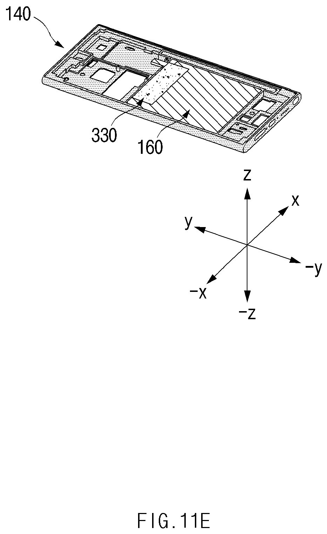

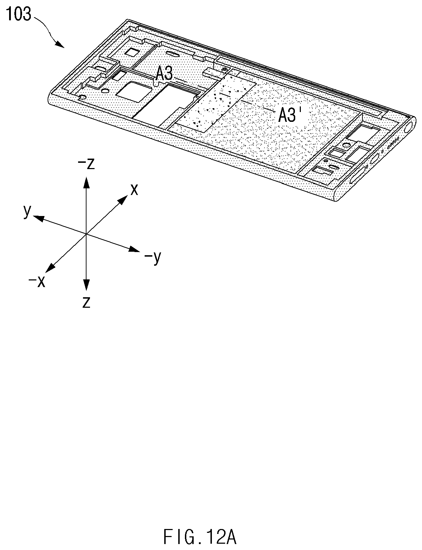

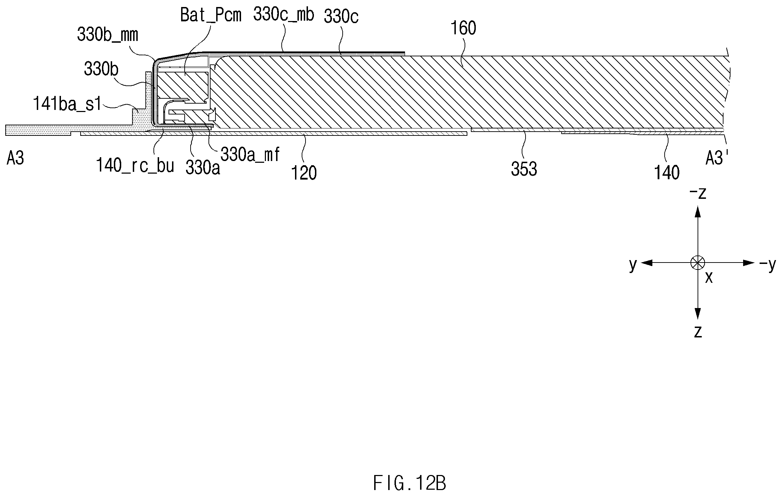

FIG. 10 is a view illustrating an example of an exploded perspective view of a third-type portable electronic device according to an embodiment. FIGS. 11A, 11B, 11C, 11D and 11E are views illustrating an example of an assembly sequence of a third-type portable electronic device according to an embodiment. FIGS. 12A and 12B are view illustrating a perspective view and a cross-sectional view of some components of a third-type portable electronic device. FIG. 12B is a view of one side of a support member, with one side thereof cut away along cutting line A3-A3', according to an embodiment. . As used hereafter, "FIG. 11" may refer to one or more among FIGS. 11A, 11B, 11C, 11D and 11E As used hereafter, "FIG. 12" may refer to one or more among FIGS. 12A and 12B.

Referring to FIGS. 1A to 10, a third-type portable electronic device 103 may include a support member 140 (or a bracket, a frame, or a housing), a display module 110 (or a display assembly, a display structure, or a display assembly) (e.g., a structure including the front plate 402 and the display 401 of FIGS. 1A and 1B), a battery 160, and a rear case 170 (e.g., the rear plate 411 of FIGS. 1A and 1B, and the rear case 170 of FIG. 1C). According to an embodiment, the third-type portable electronic device 103 may include a heat dissipation structure 120, at least a portion of which is disposed between the support member 140 and the display module 110, and a third-type fixing structure 350 (e.g., a fourth mask member 330 and a third structure body 353) (or a second battery fixing structure, a second battery adhesive structure, a second adhesive structure, a second adhesive member, or a second adhesive assembly) disposed between the support member 140 and the battery 160.

Additionally or alternatively, the third-type portable electronic device 103 may include at least one of the printed circuit boards 181 and 182 described above with reference to FIG. 1C. Furthermore, according to an embodiment, the third-type portable electronic device 103 may include the first and second adhesive members 131 and 132 for fixing the heat dissipation structure 120 to one side of the support member 140, as described above in the process of describing the first-type portable electronic device 101.

In the configuration of the third-type portable electronic device 103 described above, the display module 110, the heat dissipation structure 120, the support member 140, the battery 160, and the rear case 170 may have the same as or similar configurations to the display module, the heat dissipation structure, the support member, the battery, and the rear case described above with reference to the first-type portable electronic device 101 or the second-type portable electronic device 102, and thus, detailed descriptions thereof may be replaced by the descriptions provided above.

The third structure body 353 may be disposed between the support member 140 and the battery 160. The third-type fixing structure 350 may be partially cut away or removed so as to be disposed not to overlap the fourth mask member 330 when viewed in the z-axis direction. Alternatively, at least a portion of an area of the third-type fixing structure 350 which surrounds the fourth mask member 330 may be disposed to overlap a peripheral portion of the fourth mask member 330. At least a portion of a shape, a material, and a size of the third structure body 353 may be configured to be the same as or similar, within a predetermined error range, to at least a portion of a material and a size of the second structure body 253 described above with reference to the second-type fixing structure 250.

Referring to FIGS. 10 and 11, when observed in the z-axis direction in a stacked state of the components of the third-type portable electronic device 103, a portion of the fourth mask member 330 may be adhered to one surface of the support member 140 in the -z-axis direction, and another portion of the fourth mask member 330 may be disposed between the support member 140, on which the heat dissipation structure 120 is disposed (or the second portion 120b of the heat dissipation structure 120) and the battery 160.

Referring to FIGS. 10 and 12, the fourth mask member 330 may include a second mask upper member 330a which is adhered to one portion of the support member 140, a second mask intermediate member 330b which is connected to the second mask upper member 330a, and a second mask lower member 330c which is connected to the second mask intermediate member 330b and is disposed to surround one side of the battery 160.

The second mask upper member 330a may be formed of an adhesive material or may be configured in a form of a double-sided tape. The second mask upper member 330a may be adhered on a partial area 140_rc_bu of the battery area 140_rc of the support member 140. The second mask upper member 330a may, when observed in the z-axis direction or the -z-axis direction, overlap at least a partial area of a PCM Bat_Pcm of the battery 160 and the partial area 140_rc_bu. The second mask upper member 330a may include a second mask upper end rear surface 330a_mf, which is disposed on one surface in the -z-axis direction. The second mask upper end rear surface 330a_mf may include a non-adhesive mask member or may include a state in which an adhesive material is removed. The second mask upper end rear surface 330a_mf may be disposed to face the PCM Bat_Pcm of the battery 160. Correspondingly, the power control module (PCM) Bat_Pcm of the battery 160 may have a non-adhesive state with the second mask upper member 330a.

The second mask intermediate member 330b may be disposed between the second mask upper member 330a and the second mask lower member 330c. The second mask intermediate member 330b may have a same as or similar structure or material to the second mask upper member 330a and the second mask lower member 330c. As an example, the second mask intermediate member 330b may connect the second mask upper member 330a and the second mask lower member 330c. The intermediate mask upper member 330b may be formed of an adhesive material or may be configured in a form of a double-sided tape. Alternatively, the second mask intermediate member 330b may be formed as a non-adhesive structure. The second mask intermediate member 330b may be disposed to face one side of the PCM Bat_Pcm of the battery 160. The second mask intermediate member 330b may include a mask intermediate portion 330b_mm, which is formed on one surface (e.g., a surface which faces the y-axis). The mask intermediate portion 330b_mm may be formed of a non-adhesive material, may include a non-adhesive mask member, or may be formed by removing an adhesive material applied to the second mask intermediate member 330b. The mask intermediate portion 330b_mm may be disposed between the battery upper side wall 141ba_s1 and the second mask intermediate member 330b, so that the second mask intermediate member 330b and the battery upper side wall 141ba_s1 may maintain a non-adhesive state.

The second mask lower member 330c may extend from one end of the second mask intermediate member 330b, and may be disposed to be spaced apart from one surface of the battery 160 (e.g., a surface which faces the -z-axis), or at least a portion thereof (or partially) may be adhered to one surface of the battery 160. As an example, the second mask lower member 330c may include a second mask lower end rear surface 330c_mb, to which an adhesive material is not applied (or in which an adhesive member is not disposed, an adhesive material is removed, or a non-adhesive member is disposed). The fourth mask member 330 described above may reduce movement of the battery 160, by having one side (e.g., the second mask upper member 330a) adhered to one side of the support member 140, and by surrounding the battery 160 with a remaining portion thereof, at least a portion of which has an adhesive state with the battery 160.

Referring to FIGS. 10 to 12, as in state 1201, the third-type portable electronic device 103 may include at least the support member 140, the heat dissipation structure 120, the third-type fixing structure 350 (e.g., the fourth mask member 330 and the third structure body 353), and the battery 160. The heat dissipation structure 120 may be positioned on one surface of the support member 140 (e.g., a surface which faces the z-axis direction). In this process, while the second portion of the heat dissipation structure 120 is positioned in the second structure disposition area of the support member 140, front and rear surfaces of which are passed through, a rear surface of the second portion of the heat dissipation structure 120 may be disposed to be exposed in the -z-axis direction of the support member 140. As an example, the second portion of the heat dissipation structure 120 may be disposed so that at least a portion thereof is exposed through the battery area 140_rc of the support member 140.

As in state 1203, while the second portion of the heat dissipation structure 120 is exposed in the -z-axis direction through the battery area 140_rc, a portion of the fourth mask member 330 (e.g., the second mask upper member 330a) may be adhered to a partial area 140_rc_bu of the support member 140, which does not overlap the second portion of the heat dissipation structure 120 (e.g., a partial area on which the power control module (PCM) Bat_Pcm of the battery 160 is positioned). The second mask upper member 330a may be adhered to a bottom surface of the support member 140 between the battery upper side wall 141ba_s1 formed in the battery area 140_rc and the second portion of the heat dissipation structure 120.

As in state 1205, while the second mask upper member 330a of the fourth mask member 330 is adhered to one area of the support member 140 which does not overlap the second portion of the heat dissipation structure 120, the third structure body 353 may be adhered to a bottom surface of the battery area 140_rc of the support member 140. A front surface and a rear surface of the third structure body 353 may be applied with an adhesive material (or a first adhesive material disposed on a front surface and a second adhesive material disposed on a rear surface) or may be configured in a form of a double-sided adhesive tape. In the illustrated drawings, the third structure body 353 is illustrated in a form which includes a hole corresponding to a sensor disposition area, but the disclosure is not limited thereto. For example, a hole, in which a sensor is disposed, of the third structure body 353 may be removed, and an adhesive material (e.g., a first adhesive material disposed on a front surface and a second adhesive material disposed on a rear surface) may be formed on the front and rear surfaces in the same manner as surrounding portions. The third structure body 353 may include a first opening (e.g., the first opening 253op of FIG. 8), which does not overlap the second portion of the heat dissipation structure 120. Accordingly, when observed in the -z-axis direction, the third structure body 353 and the second portion of the heat dissipation structure 120 may be disposed so as not to overlap each other.

As in state 1207, while the second portion of the heat dissipation structure 120 and the third structure body 353 are disposed in the battery area 140_rc of the support member 140 so as not to overlap each other, the battery 160 may be stacked on the heat dissipation structure 120 and the third structure body 353. After the battery 160 is stacked, the fourth mask member 330 may be folded to surround a surface of the battery 160 in the -z-axis direction. In this process, at least a portion of the second mask intermediate member 330b and the second mask lower member 330c, which include an adhesive material, may be adhered to the battery 160.

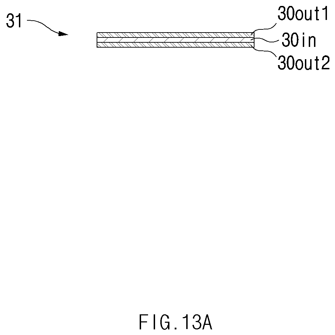

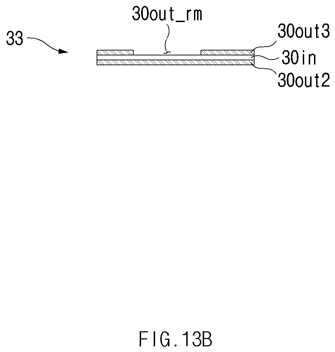

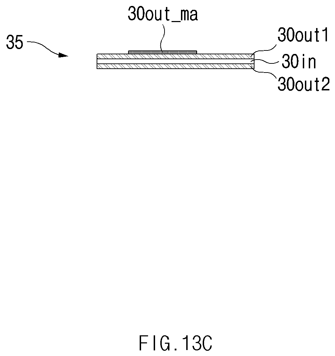

FIGS. 13A, 13B and 13C are views illustrating an example of at least some components of a fixing structure according to an embodiment. As used hereafter, "FIG. 13" may refer to one or more among FIGS. 13A, 13B and 13C.

Referring to FIGS. 1C to 13, a structure body 31 according to an embodiment may include a structure body of at least one type of fixing structure among various types of fixing structures described above with reference to FIGS. 1C to 12. As an example, the structure body 31 may include a first sheet 30in (or a first layer, a first sheet layer, a core material, a first substrate, or a first plate), a first upper sheet 30out1 (or a first outer sheet), and a first lower sheet 30out2 (or a second outer sheet). The first sheet 30in may include a sheet which is formed of a non-adhesive material. The first sheet 30in may be formed of at least one of various materials or a mixed material of a plurality of materials. Alternatively, in the illustrated drawings, a structure in which the first sheet 30in is formed as a single layer is illustrated, but the first sheet 30in may include a plurality of layers. As an example, the first sheet 30in may include at least one of a polymer structure, a metal or non-metal mesh structure, plastic, a metal or non-metal plate, a synthetic fiber or natural fiber structure, and a rubber structure. The first upper sheet 30out1 may be stacked on an upper side of the first sheet 30in. The first upper sheet 30out1 may be formed of an adhesive material. Alternatively, the first upper sheet 30out1 may be formed of an adhesive tape. The first upper sheet 30out1 may have at least one of the same size and shape as the first sheet 30in. The first lower sheet 30out2 may be formed of an adhesive material or an adhesive tape in the same as or similar manner to the first upper sheet 30out1. Alternatively, the first lower sheet 30out2 may be formed of the same material as the first upper sheet 30out1. The first lower sheet 30out2 may have at least one of the same size and shape as the first upper sheet 30out1 and the first sheet 30in. Meanwhile, the first upper sheet 30out1 and the first lower sheet 30out2 may, when applied to a portable electronic device, be named a lower sheet and an upper sheet, respectively, for distinguishing positions of the sheets with reference to the illustrated drawings.

A first fixing structure 33 according to an embodiment may be configured through a form in which at least a portion of the first upper sheet 30out1 of the structure body 31 described above is removed. As an example, the first fixing structure 33 may include the first sheet 30in, a second upper sheet 30out3, and the first lower sheet 30out2. The first sheet 30in and the first lower sheet 30out2 may have at least one of the same shape, size, and material as the first sheet and the first lower sheet of the structure body 31 described above. The second upper sheet 30out3 may be disposed to cover an upper surface (or a front surface) of the first sheet 30in, and may include a removal area 30out_rm, a portion of which is removed. The removal area 30out_rm of the second upper sheet 30out3 may be referred to as at least one hole or opening from a side of the second upper sheet 30out3. The removal area 30out_rm may be formed in an area corresponding to at least one of the first mask member 151 and the second mask member 152 described above with reference to FIG. 1C. As an example, in the first-type fixing structure 150 described above with reference to FIG. 1C, the first mask member 151 may be omitted, and a removal area 30out_rm corresponding to the first mask member 151 may be formed on the structure body 153. The removal area 30out_rm of the structure body 153 may face the second portion of the heat dissipation structure 120, so that the second portion of the heat dissipation structure 120 does not contact the structure body 153. The removal area 30out_rm described above may be applied in the same manner to an area in which the second mask member 152 is disposed. As described above, in an embodiment of the disclosure, a fixing structure may be configured not by adding a mask member to a structure body, but by removing at least a portion of the structure body.

A second fixing structure 35 according to an embodiment may include a structure in which a fifth mask member 30out_ma is added on the structure body 31 described above. According to an embodiment, the second fixing structure 35 may include the structure body 31 and the fifth mask member 30out_ma described above. The structure body 31 may include the first sheet 30in, the first upper sheet 30out1, and the first lower sheet 30out2, and the fifth mask member 30out_ma may be positioned on the first upper sheet 30out1 (or the first lower sheet 30out2). An area, on which the fifth mask member 30out_ma is positioned, may be any one of an area corresponding to the second portion 120b of the heat dissipation structure 120 described above with reference to FIG. 1C, and a sensor disposition area (e.g., at least a partial area of an area in which a biometric sensor is disposed). The fifth mask member 30out_ma may include a same as or similar material to the first sheet 30in. As an example, the fifth mask member 30out_ma may include at least one of a polymer structure, a sponge, and a mesh structure. Alternatively, the fifth mask member 30out_ma may include a structure, in which a polymer structure and a sponge structure overlap each other, or may include a sheet, in which a sponge structure is formed of a polymer material.

The fixing structure 33 (or 35) described above with reference to FIG. 13 may be applied to at least one of the first-type fixing structure 150, the second-type fixing structure 250, and the third-type fixing structure 350 described above. Additionally or alternatively, in some embodiments, a plurality of fixing structures may be applied together. For example, a specific portable electronic device 400, 101, 102, or 103 may include at least one of the first-type fixing structure 150, the second-type fixing structure 250, and the third-type fixing structure 350.

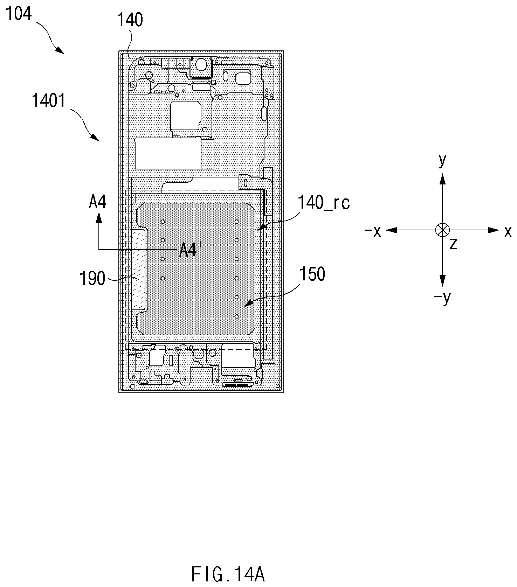

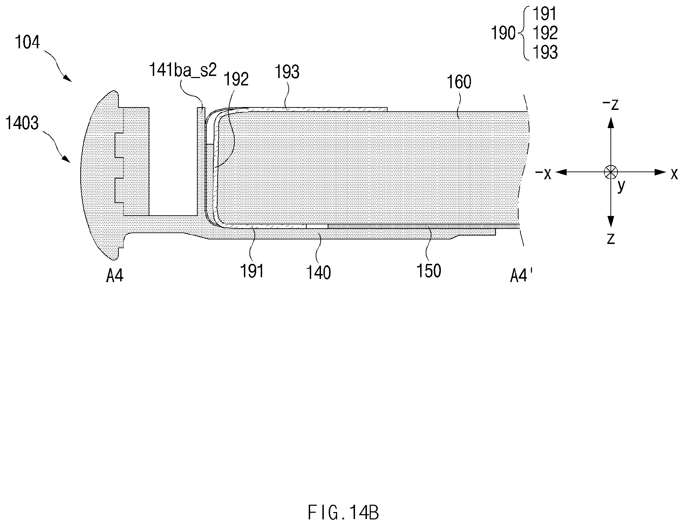

FIGS. 14A and 14B are views illustrating an example of a structure of a fourth-type portable electronic device according to an embodiment. As used hereafter, "FIG. 14" may refer to one or more among FIGS. 14A and 14B.

Referring to FIG. 14, a fourth-type portable electronic device 104 according to an embodiment may include, for example, the support member 140, the first-type fixing structure 150, the battery 160, and a battery detachment structure 190. State 1401 of FIG. 14 illustrates a state in which the battery detachment structure 190 and the first-type fixing structure 150 are seated on the support member 140, and state 1403 illustrates an example of a cross-sectional view taken along cutting line A4-A4' after the battery 160 is seated on the first-type fixing structure 150 in state 1401. Additionally or alternatively, the fourth-type portable electronic device 104 may further include at least some of components included in other types of portable electronic devices described above with reference to FIGS. 1A to 13.

The support member 140 may include a same as or similar configuration to the support member described above with reference to FIG. 1C. For example, the support member 140 may include a battery area 140_rc, in which the battery 160, in which the battery detachment structure 190 is installed, is seated at least partially. The battery area 140_rc may include a bottom surface, on which the battery 160 is seated, and at least one side wall which extends in the z-axis direction from a periphery of the bottom surface (e.g., the battery upper side wall 141ba_sl of FIG. 10, or an illustrated battery side wall 141ba_s2).

According to an embodiment, when a cross section taken along cutting line A4-A4' with respect to the battery 160 seated in the battery area 140_rc is viewed, the fourth-type portable electronic device 104 may include a first battery release portion 191, which is disposed between a bottom surface of the support member 140 and the battery 160, a second battery release portion 192, which is connected to one end of the first battery release portion 191 and is disposed between the battery side wall 141ba_s2 and one side surface of the battery 160 (e.g., a side surface which faces the -x-axis), and a third battery release portion 193, which is connected to one end of the second battery release portion 192 and is positioned on an upper surface of the battery 160 (e.g., a surface which faces the -z-axis or a front surface). The first battery release portion 191 may not be adhered to a bottom surface of the support member 140, and may have an adhesive state with a portion of a bottom surface of the battery 160 (e.g., a portion of a surface which faces the z-axis). In this regard, an adhesive material or a double-sided adhesive tape may be disposed between the first battery release portion 191 and the battery 160. The second battery release portion 192 may be configured so as not to be adhered to the battery side wall 141ba_s2. The second battery release portion 192 may be applied with an adhesive material or may include a double-sided adhesive tape so as to be adhered to one side surface of the battery 160 (e.g., a side surface which faces the -x-axis), but the disclosure is not limited thereto. For example, the second battery release portion 192 may have a non-adhesive state with one side surface of the battery 160. At least a portion of the third battery release portion 193 may be disposed to have an adhesive state with an upper surface of the battery 160 (e.g., a surface which faces the -z-axis or a front surface, which may become a lower surface depending on an observation direction), and, in this regard, an adhesive material or a double-sided adhesive tape may be disposed between the third battery release portion 193 and the upper surface of the battery 160. As an example, the third battery release portion 193 may be configured to have a non-adhesive state with an upper surface of the battery 160. At least a portion of a lower surface of the battery 160 (e.g., a surface which faces the z-axis or a rear surface) may be adhered to a bottom surface of the support member 140 by the first-type fixing structure 150. In the structure described above, an operator may, after gripping the third battery release portion 193, release an adhesive state between the battery 160 and the first-type fixing structure 150 by pulling the third battery release portion 193 in one direction (e.g., the - z-axis direction).

Meanwhile, in the description provided above, a battery release structure 190 for releasing a state in which the first-type fixing structure 150 is adhered to one surface of the support member 140 (e.g., a bottom surface) is illustrated, but the disclosure is not limited thereto. For example, the first-type fixing structure 150, which is described as a component included in the fourth-type portable electronic device 104, may be replaced with either the second-type fixing structure 250 or the third-type fixing structure 350 described above. Furthermore, the first-type fixing structure 150 may also be in a form of any one of the fixing structures described above with reference to FIG. 13.

In the description provided above, various types of portable electronic devices are illustrated, but the fixing structures described for each type may be applied in the same as or similar manner to other types of portable electronic devices. As an example, the first-type fixing structure 150, which is applied to the first-type portable electronic device 101, may be applied to replace the second-type fixing structure 250 described in the second-type portable electronic device 102 or the third-type portable electronic device 103.

As described above, a portable electronic device according to an embodiment may include a support member 140 which includes a first surface (or a front surface) and a second surface (or a rear surface), a display module 110 (or a display module which is positioned in a direction toward the first surface of the support member 140), a printed circuit board 181 and a battery 160 (or a printed circuit board and a battery which are positioned at least partially in a direction toward the rear surface of the support member 140), a heat dissipation structure 120, at least a portion of which is disposed between the first surface of the support member 140 and the display module 110, and a fixing structure 150, which is positioned between the support member 140 and the battery 160. The heat dissipation structure may include a first portion 120a, which is positioned in a first area 140ch1 of the support member, and a second portion 120b, which is positioned in a second area 140ch2 (or an opening) of the support member, where at least a portion of front and rear surfaces of the second area is opened, and the second portion 120b may be exposed to the second surface of the support member through the opened second area. The fixing structure 150 may include an upper surface 150_f, which faces the second portion of the heat dissipation structure and includes a non-adhesive area which does not adhere to the second portion, and a lower surface 150_b, which includes a lower adhesive area which is adhered to the battery.

According to an embodiment, an air gap may be formed at at least a portion between the fixing structure and the second portion of the heat dissipation structure.

According to an embodiment, the first area may include a groove corresponding to a size and a shape of the first portion, and the second area (or the opening) may include a first opening corresponding to a size and a shape of the second portion.

According to an embodiment, the portable electronic device may further include at least one of a first adhesive member 131, which is disposed between the first portion of the heat dissipation structure and the groove formed in the first area, and a second adhesive member 132, which is disposed between a periphery of the second portion of the heat dissipation structure and the first area.

According to an embodiment, the fixing structure may include a structure body 153, which includes first and second adhesive materials disposed on front and rear surfaces, and a first mask member 151, which is disposed on a portion of the structure body which faces the second portion to form the non-adhesive area.

According to an embodiment, the first mask member may include at least one of a polymer structure, a metal mesh structure, a non-metal mesh structure, a plastic structure, a metal plate, a non-metal plate, a synthetic fiber structure, a natural fiber structure, and a rubber structure.

According to an embodiment, the first mask member may include a plurality of layers, and the plurality of layers may include a mesh-structure layer and a polymer-structure layer.

According to an embodiment, the fixing structure may include a structure body 33 which includes a first adhesive material (or a third adhesive material) disposed on a front surface and a second adhesive material (or a fourth adhesive material) partially disposed on a rear surface, and the non-adhesive area may include an area, in which the second adhesive material on the rear surface is not disposed.

According to an embodiment, at least a portion between the upper surface and the second portion may form an air gap.

According to an embodiment, the portable electronic device may further include a sensor 180bi which is disposed under the display, and the sensor 180bi may be disposed in a second opening 140bi which is formed in the support member.

According to an embodiment, the fixing structure 150 may include a structure body 153 which includes first and second adhesive materials (or fifth and sixth adhesive materials) disposed on front and rear surfaces, a first mask member 151 which is disposed on the structure body 153 to form the non-adhesive area, and a second mask member 152 which is disposed between the sensor and the structure body.

According to an embodiment, the fixing structure 250 may include a structure body 253 which includes a first adhesive material (or a seventh adhesive material) disposed on a front surface and a second adhesive material (or an eighth adhesive material) disposed on a rear surface, and a first opening which corresponds to the second portion of the heat dissipation structure, and may further include a third mask member 230 which forms the non-adhesive area.

In an embodiment, the third mask member may include a first mask upper member which is disposed in a mask adhesive area of a second surface of the support member, and a first mask lower member which is connected to the first mask upper member and forms a non-adhesive area.

In an embodiment, the first mask upper member may include a first adhesive material (or a ninth adhesive material) which is adhered to the mask adhesive area, and the first mask lower member may include a second adhesive material (or a tenth adhesive material) which is disposed between one surface of the battery and the second surface of the support member, and is disposed in a direction which faces one surface of the battery.

In an embodiment, the fixing structure 350 may include a structure body 353 which includes first and second adhesive materials disposed on front and rear surfaces thereof and includes an opening formed at a position corresponding to the second portion of the heat dissipation structure, a second mask upper member 330a which is disposed on one side of a second surface of the support member, a second mask intermediate member 330b which is connected to the second mask upper member and at least partially faces a side surface of the battery, and a second mask lower member 330c which is connected to the second mask intermediate member and is positioned on an exposed partial surface of the battery.

In an embodiment, the second mask upper member may include an adhesive material which is disposed on a surface which faces the support member.

In an embodiment, the second mask intermediate member may be disposed to have a non-adhesive state with respect to a side wall of a battery area on which the battery is seated.

In an embodiment, at least a portion of the second mask lower member may be disposed in a non-adhesive state with one surface of an exposed partial surface of the battery.

In an embodiment, the fixing structure 35 may include an inner core portion 30in, an upper sheet 30out1 which is formed on a first surface of the inner core portion and forms an upper adhesive area, a lower sheet 30out2 which is formed on a second surface of the inner core portion and forms a lower adhesive area, and a mask member 30out_ma which is positioned on the lower sheet and forms the non-adhesive area.

In an embodiment, an air gap may be formed at at least a portion between the mask member and the second portion of the heat dissipation structure.

A portable electronic device according to an embodiment may include a support member 140 which includes front and rear surfaces and includes an opening 140ch2, depending on a definition of surfaces or a definition manner of areas, a display module 110, a printed circuit board 181, a battery 160, a heat dissipation structure 120 of which at least a portion is disposed between a front surface of the support member and the display module, and a double-sided adhesive member 150 which attaches the battery to a portion of a rear surface of the support member. Furthermore, the heat dissipation structure may include a first portion 120a which is positioned in a first area 140ch1 of the support member, and a second portion 120b which at least partially overlaps with an opening of the support member, and the double-sided adhesive member may be described as including a front surface 150_f which includes a first adhesive area adhered to the support member and a non-adhesive area which faces the second portion of the heat dissipation structure, and a rear surface 150_b which includes a second adhesive area adhered to the battery.

In an embodiment, a size of a surface area of the second adhesive area may be equal to a sum of a size of a surface area of the non-adhesive area and a size of a surface area of the first adhesive area.

The non-adhesive area may be formed by attaching a masking layer to a front surface of the double-sided adhesive member, and the masking layer may be formed in a shape corresponding to an opening formed in the support member, so as to maintain an air gap with the heat dissipation structure.

In an embodiment, an air gap may be formed at at least a portion between the double-sided adhesive member and the second portion of the heat dissipation structure.

In an embodiment, the first area may include a groove which corresponds to a size and a shape of the first portion, and the opening may correspond to a size and a shape of the second portion.

In an embodiment, the double-sided adhesive member may include a structure body 153 which includes first and second adhesive materials disposed on front and rear surfaces thereof, and a first mask member 151 which is disposed at a portion of the structure body which faces the second portion and forms the non-adhesive area.

In an embodiment, the double-sided adhesive member may include a structure body 33 which includes a first adhesive material disposed on a front surface of the double-sided adhesive member and a second adhesive material partially disposed on a rear surface of the double-sided adhesive member, and the non-adhesive area may include an area on the rear surface of the double-sided adhesive member in which the second adhesive material is not disposed.

According to an embodiment, at least a portion of the front surface and the second portion may form an air gap.

In an embodiment, the portable electronic device may further include a sensor 180bi which is disposed under the display module, and the sensor may be disposed in an opening 140bi formed in the support member.

In an embodiment, the double-sided adhesive member 150 may include a structure body 153 which includes first and second adhesive materials disposed on front and rear surfaces thereof, a first mask member 151 which is disposed on the structure body and forms the non-adhesive area, and a second mask member 152 which is disposed between the sensor and the structure body.

In an embodiment, the double-sided adhesive member 250 may include a structure body 253 which includes a first adhesive material disposed on a front surface of the double-sided adhesive member and a second adhesive material disposed on a rear surface of the double-sided adhesive member, and includes an opening corresponding to the second portion of the heat dissipation structure, and a third mask member 230 which forms the non-adhesive area.

In an embodiment, the double-sided adhesive member 350 may include a structure body 353 which includes first and second adhesive materials disposed on front and rear surfaces thereof and includes an opening formed at a position corresponding to the second portion of the heat dissipation structure, a second mask upper member 330a which is disposed on one side of a second surface of the support member, a second mask intermediate member 330b which is connected to the second mask upper member and at least partially faces a side surface of the battery, and a second mask lower member 330c which is connected to the second mask intermediate member and is positioned on an exposed partial surface of the battery.

In an embodiment, the double-sided adhesive member 35 may include an inner core portion 30in, an upper sheet 30out1 which is formed on a first surface of the inner core portion and forms an upper adhesive area, a lower sheet 30out2 which is formed on a second surface of the inner core portion and forms a lower adhesive area, and a mask member 30out_ma which is positioned on the lower sheet and forms the non-adhesive area.

Ordinal expressions, such as "first," "second," "third," or "fourth," described in the detailed description of the invention are provided merely to distinguish corresponding components from other components, and may be omitted or replaced with other terms without changing the meaning of the corresponding components.

The electronic device according to various embodiments disclosed in the disclosure may be various types of devices. The electronic device may include, for example, a portable communication device (e.g., a smartphone), a computer device, a portable multimedia device, a mobile medical appliance, a camera, a wearable device, or a home appliance. An electronic device according to an embodiment of the disclosure may not be limited to the above-described electronic devices.

Various embodiments of the disclosure and terms used herein are not intended to limit the technical features described in the disclosure to specific embodiments, and it should be understood that the embodiments and the terms include modification, equivalent, or alternative on the corresponding embodiments described herein. With regard to description of drawings, similar or related components may be marked by similar reference marks/numerals. The singular form of the noun corresponding to an item may include one or more of items, unless interpreted otherwise in context. In the disclosure, the expressions "A or B", "at least one of A and B", "at least one of A or B", "A, B, or C", "at least one of A, B, and C", and "at least one of A, B, or C" may include any and all combinations of one or more of the associated listed items. The terms, such as "first" or "second" may be used to simply distinguish the corresponding component from the other component, but do not limit the corresponding components in other aspects (e.g., importance or order). When a component (e.g., a first component) is referred to as being "coupled with/to" or "connected to" another component (e.g., a second component) with or without the term of "operatively" or "communicatively", it may mean that a component is connectable to the other component, directly (e.g., by wire), wirelessly, or through the third component.

In various embodiments of the disclosure, the term "module" used herein may include a unit, which is implemented with hardware, software, or firmware, and may be interchangeably used with the terms "logic", "logical block", "part", or "circuit". The "module" may be a minimum unit of an integrated part or may be a minimum unit of the part for performing one or more functions or a part thereof. For example, according to an embodiment, the module may be implemented in the form of an application-specific integrated circuit (ASIC).

Various embodiments of the disclosure may be implemented as software (e.g., a program) including one or more instructions stored in a storage medium (e.g., an embedded memory or an external memory) readable by a machine (e.g., a portable electronic device). For example, the processor of a machine (e.g., the portable electronic device) may call at least one instruction of the stored one or more instructions from a storage medium and then may execute the at least one instruction. This enables the machine to operate to perform at least one function depending on the called at least one instruction. The one or more instructions may include a code generated by a complier or a code executable by an interpreter. The machine-readable storage medium may be provided in the form of a non-transitory storage medium. Herein, 'non-transitory' just means that the storage medium is a tangible device and does not include a signal (e.g., electromagnetic waves), and this term does not distinguish between the case where data is semipermanently stored in the storage medium and the case where the data is stored temporarily.

According to an embodiment, a method according to various embodiments disclosed the disclosure may be provided to be included in a computer program product. The computer program product may be traded between a seller and a buyer as a product. The computer program product may be distributed in the form of a machine-readable storage medium (e.g., compact disc read only memory (CD-ROM)) or may be distributed (e.g., downloaded or uploaded), through an application store (e.g., PlayStore^{™}), directly between two user devices (e.g., smartphones), or online. In the case of on-line distribution, at least part of the computer program product may be at least temporarily stored in the machine-readable storage medium such as the memory of a manufacturer's server, an application store's server, or a relay server or may be generated temporarily.

According to various embodiments, each component (e.g., a module or a program) of the above-described components may include a single entity or a plurality of entities, and some of the plurality of objects may be separately arranged on other components. According to various embodiments, one or more components of the above-described components or operations may be omitted, or one or more other components or operations may be added. Alternatively or additionally, a plurality of components (e.g., a module or a program) may be integrated into one component. In this case, the integrated component may perform one or more functions of each component of the plurality of components in the manner same as or similar to being performed by the corresponding component of the plurality of components prior to the integration. According to various embodiments, operations executed by modules, programs, or other components may be executed by a successive method, a parallel method, a repeated method, or a heuristic method. Alternatively, at least one or more of the operations may be executed in another order or may be omitted, or one or more operations may be added.

## Claims

1. A portable electronic device, comprising:
a support member including a front surface and a rear surface, the support member including an opening formed therein;
a display module;
a printed circuit board;
a battery;
a heat dissipation structure at least partially disposed between the support member and the display module; and
a double sided adhesive member which attaches the battery to a portion of the rear surface of the support member,
wherein the heat dissipation structure includes:
a first portion disposed on a first area of the support member; and
a second portion at least partially overlapping with the opening of the support member; and
wherein the double sided adhesive member includes:
a front surface including a first adhesive area bonded to the support member, and a non-adhesive area which faces the second portion of the heat dissipation structure; and
a rear surface including a second adhesive area bonded to the battery.

2. The portable electronic device of claim 1, wherein a surface area of the second adhesive area is substantially equal to a sum of a surface area of the first adhesive area and a surface area of the non-adhesive area.

3. The portable electronic device of claim 1,
wherein the non-adhesive area at the front surface of the double sided adhesive member includes a masking layer attached to the front surface of the double sided adhesive member,
wherein at least a portion of the masking layer is shaped corresponding to the opening formed in the support member, and
wherein the masking layer forms an air gap with the heat dissipation structure.

4. The portable electronic device of claim 1, further comprising:
an air gap formed between the double sided adhesive member and the second portion of the heat dissipation structure.

5. The portable electronic device of claim 1,
wherein the first area includes a groove formed therein, the groove corresponding to a size and a shape of the first portion of the heat dissipation structure, and
wherein the second area includes a first opening corresponding to a size and a shape of the second portion of the heat dissipation structure.

6. The portable electronic device of claim 5, further comprising at least one of:
a first adhesive member disposed between the first portion of the heat dissipation structure and the groove formed in the first area; and
a second adhesive member disposed between an edge of the second portion of the heat dissipation structure and the first area.

7. The portable electronic device of claim 1, wherein the double sided adhesive member includes:
a structure body having a first adhesive material disposed on a front surface of the structure body, and a second adhesive material disposed on a rear surface of the structure body; and
a first mask member disposed on a portion of the structure body facing the second portion to form the non-adhesive area.

8. The portable electronic device of claim 7,
wherein the first mask member comprises a plurality of layers, and
wherein the plurality of layers include a mesh structure layer and a polymer structure layer.

9. The portable electronic device of claim 1, wherein the double sided adhesive member includes:
a structure body having a first adhesive material disposed on a front surface of the structure body, and a second adhesive material disposed on a portion of a rear surface of the structure body; and
wherein the non-adhesive area includes an area on the rear surface of the structure body, where the second adhesive material is not disposed.

10. The portable electronic device of claim 1, further comprising:
a sensor disposed below the display module;
wherein the sensor is disposed in a second opening formed in the support member, and
wherein the double sided adhesive member includes;
a structure body having a first adhesive material disposed on a front surface of the structure body, and a second adhesive material disposed on a rear surface of the structure body;
a first mask member disposed on the structure body to form the non-adhesive area; and
a second mask member disposed between the sensor and the structure body.

11. The portable electronic device of claim 1, wherein the double sided adhesive member includes:
a structure body having a first adhesive material disposed on a front surface of the structure body, and a second adhesive material disposed on a rear surface of the structure body, the structure body having a first opening formed therein and corresponding to the second portion of the heat dissipation structure;
a third mask member forming the non-adhesive area.

12. The portable electronic device of claim 11,
wherein the third mask member includes:
a first mask upper member disposed on a mask adhesive area of the rear surface of the support member; and
a first mask lower member connected to the first mask upper member and forming the non-adhesive area,
wherein the first mask upper member includes a first adhesive material which adheres to the mask adhesive area, and
wherein the first mask lower member includes a second adhesive material disposed between a first side of the battery and the rear surface of the support member, the second adhesive material disposed in a direction facing the first side of the battery.

13. The portable electronic device of claim 1,
wherein the double sided adhesive member includes:
a structure body having a first adhesive material disposed on a front surface of the structure body, and a second adhesive material disposed on a rear surface of the structure body, the structure body having a second opening formed therein at a position corresponding to the second portion of the heat dissipation structure;
a second mask upper member disposed on one side of the rear surface of the support member;
a second mask intermediate member connected to the second mask upper member and at least partially facing a side of the battery and a sidewall of the support member inside which the battery is accommodated; and
a second mask lower member connected to the second mask intermediate member and disposed on an upper portion of the battery,
wherein the second mask upper member includes an adhesive material disposed on a surface facing the support member,
wherein the second mask intermediate member is disposed in a non-adhesive state with the sidewall of the support member, and
wherein at least a portion of the second mask lower member is disposed in a non-adhesive state with the upper portion of the battery.

14. The portable electronic device of claim 1, wherein the double sided adhesive member includes:
an inner core portion;
an upper sheet formed on a first side of the inner core portion, the upper sheet forming an upper adhesive area of the double sided adhesive member;
a lower sheet formed on a second surface of the inner core portion, the lower sheet forming a lower adhesive area of the double sided adhesive member; and
a mask member disposed on the lower sheet and forming the non-adhesive area of the double sided adhesive member.

15. The portable electronic device of claim 14, further comprising:
an air gap formed between the mask member and the second portion of the heat dissipation structure.
